Europäisches Patentamt

European Patent Office

Office européen des brevets

(19)

(11) **EP 0 427 759 B1**

(12) # EUROPEAN PATENT SPECIFICATION

(45) Date of publication and mention
of the grant of the patent:
**28.10.1998  Bulletin 1998/44**

(21) Application number: **89908760.5**

(22) Date of filing: **01.08.1989**

(51) Int Cl.[6]: **G01R 33/20**

(86) International application number:
**PCT/US89/03318**

(87) International publication number:
**WO 90/01705 (22.02.1990 Gazette 1990/05)**

(54) **PROBE FOR HIGH RESOLUTION NMR WITH SAMPLE REORIENTATION**

SONDE FÜR HOHE AUFLÖSUNG NMR MIT WIEDERORIENTIERUNG DER MUSTER

SONDE POUR RMN A HAUTE RESOLUTION AVEC RE-ORIENTATION DES ECHANTILLONS

(84) Designated Contracting States:
**AT BE CH DE FR GB IT LI LU NL SE**

(30) Priority: **03.08.1988  US 227729**
        **27.06.1989  US 371916**
        **27.06.1989  US 371977**

(43) Date of publication of application:
**22.05.1991  Bulletin 1991/21**

(73) Proprietor: **THE REGENTS OF THE UNIVERSITY
OF CALIFORNIA
Oakland, California 94612-3550 (US)**

(72) Inventors:
• **PINES, Alexander
  Berkeley, CA 94708 (US)**
• **SAMOSON, Ago
  Tallinn, 200001 (SU)**

(74) Representative:
**Bühling, Gerhard, Dipl.-Chem. et al
Patentanwaltsbüro
Tiedtke-Bühling-Kinne & Partner
Bavariaring 4
80336 München (DE)**

(56) References cited:
**US-A- 4 301 410          US-A- 4 352 066
US-A- 4 511 841          US-A- 4 710 714**

• **JOURNAL OF MAGNETIC RESONANCE, vol. 72,
  no. 3, May 1987, pages 414-421, Duluth, MN, US;
  T. VÄÄNÄNEN et al.: "A variable-angle spinning
  system for the determination of NMR parameters
  of liquid-crystalline samples"**
• **MOLECULAR PHYSICS, vol. 65, no. 4, March
  1988, pages 1013-1018, Basingstoke, Hants, GB;
  A. SAMOSON et al.: "High resolution solid-state
  N.M.R. Averaging of second-order effects by
  means of a double-rotor"**
• **Haeberlen, Waugh : "Coherent Averaging
  Effects in Magnetic Resonance" ; Physical
  Review 175, 453-467 (1968)**
• **Ernst et al. : "Principles of NMR in One and Two
  Dimensions" ; ed. 1987, p 396-399.**

**Description**

BACKGROUND OF THE INVENTION

The present invention relates to the measurement of nuclear magnetic resonance (NMR) and, in particular, to the NMR measurement of polycrystalline and/or amorphous solids.

Since its discovery in 1946, Nuclear Magnetic Resonance (NMR) has become a powerful analytical tool in studies of various liquid and solid materials. It is non-invasive and gives results which can be readily interpreted. The measured chemical shifts can be immediately associated with model structural units of the substance under study. In addition, relaxation rates provide information about molecular motions. Characteristic resonance frequencies of magnetic nuclei lie in a convenient radio-frequency (RF) range and can be detected with well-known electronic techniques.

An NMR experiment may be described as follows. Nuclei may be regarded as bar magnets that, because of their charge and nuclear spin, have associated magnetic moments. These magnetic moments are randomly oriented in the absence of external forces. When placed in an external magnetic field, these nuclei have discrete spin states. A quantized amount of energy is associated with each such spin state. The energy of each such state depends on the nuclear magnetic moment of the nuclei being studied and on the magnetic field in the vicinity of the nucleus in question. This magnetic field is the superposition of the external magnetic field and the magnetic fields generated by nearby electrons and nuclei. Hence, measurements of the energy levels associated with each of the spin states can provide information about the environment of the nuclei being studied.

An NMR measurement is made by determining the energy difference between nuclear spin states. In order to accomplish this, a sample of the material in question is placed in an external magnetic field and excited by applying a second, oscillating magnetic field in a direction perpendicular to the first steady field. This is accomplished by applying oscillating RF energy across a coil positioned perpendicular to the direction of the external magnetic field. The second magnetic field is created by a pulsing current in this coil. This second field causes transitions between nuclear spin states whose energies are determined by the first field. The energy absorbed by the nuclei during such an excitation or emitted thereby after such an excitation provides information on the differences in energy between the various spin states.

The accuracy of NMR measurements depends upon the physical form of the sample being studied. Highly accurate chemical shift determinations and separation of NMR lines are possible for liquid samples due to the random tumbling and rapid reorientation of sample molecules in solution. This rapid reorientation effectively causes the surroundings of the resonating nuclei to appear isotropic on the time scale of the NMR experiment.

If polycrystalline, powdery, glassy solids, or the like are studied, however, observable lines are broadened due to different orientations of particles with respect to the static magnetic field. Anisotropic line broadening has traditionally rendered high-resolution work impossible with this type of sample.

Various methods have been employed to reduce the amount of line broadening observed for solid samples. For example, techniques in which crystalline materials are oriented in a particular direction with respect to the external magnetic field are known to the prior art. Unfortunately, such methods are impractical in many cases, since many solids cannot be obtained in single crystalline form nor oriented in a uniform direction throughout the material. In fact, many samples for which NMR spectra are desired exist only as powders or amorphous solids.

In the prior art, line broadening difficulties can be partially overcome by using magic angle spinning (MAS). Using this technique, the sample is rotated rapidly at an angle of 54.7 degrees with respect to the external magnetic field, i. e., the magic angle. For reasons that will be discussed in more detail below, this spinning removes so-called first order line broadening caused by such factors as chemical shift anisotropy, secular dipolar interactions, and first order quadrupole interactions. As a result, line widths on the order of 100 Hz are typically observed for non-quadrupole nuclei.

Although these line widths are a significant improvement over those obtained without MAS, they are still far broader than those obtained with liquid samples. Typically, line widths of 0.2 Hz are observed for liquids.

In the case of quadrupole nuclei, the line broadening is even worse. Line widths of quadrupole nuclei are determined primarily by second order quadrupole interactions, and are on the order of several Khz or more for light nuclei in strong magnetic fields. Magic angle spinning does not completely correct for this line broadening.

Moreover, from the article "Coherent Averaging Effects in Magnetic Resonance" by Haeberlen, Waugh in Physical Review 175 (1968), pages 453 to 467, the Lee-Goldburg Experiment is known. In this perturbational method a strong steady rf field is applied to a sample shifted off resonance so that the spins experience a field which makes a certain angle with the z axis. If this angle fulfills the magic angle condition, the dipolar interactions are eliminated and the chemical shifts are reduced by the common scale facter $\sqrt{3}$ to a certain degree of approximation.

Accordingly, it is an object of the present invention to provide an improved apparatus for measuring nuclear magnetic properties of solids.

It is a further object of the present invention to provide an NMR apparatus with improved resolution for structural determinations of powdered or amorphous or otherwise orientationally disordered solid samples.

These and other objects of the present invention will become apparent to those skilled in the art from the following detailed description of the invention and the accompanying drawings.

## BRIEF DESCRIPTION OF THE DRAWINGS

Figure 1 illustrates the orientation of particles in a sample holder in a magnetic field.

Figure 2 illustrates the sample and magnetization positions during an ideal NMR experiment.

Figure 3 illustrates the sample holder and sample magnetization positions during the first of two storage experiments.

Figure 4 illustrates the sample holder and sample magnetization positions during the second of two experiments two storage experiments.

Figure 5 is partially cut-away prospective view of an apparatus according to the present invention for causing the sample holder to move to each of several discrete locations.

Figure 6 illustrates the preferred embodiment an apparatus according to the present invention for moving the angle of the axis of a spinning sample holder.

Figure 7 illustrates the rotor and magnetization positions during an ideal NMR experiment.

Figure 8 illustrates the rotor and sample magnetization position during the first of two experiments used in with the present invention.

Figure 9 illustrates the rotor and sample magnetization position during the second of two experiments used in with the present invention.

Figure 10 is a schematic representation of the relative angles at which a spinning sample is oriented in an NMR instrument when positioned according to the principles of the present invention;

Figure 11 is a partial cut-away view of a spinner utilized in an apparatus according to the present invention.

Figure 12 is an exploded view of an apparatus according to the present invention for causing a sample to spin in the pattern shown in Figure 2.

Figure 13 is a cross sectional view of the apparatus shown in Figure 4 positioned between the poles of a magnet.

Figure 14(a) is an NMR spectrum of $Na^{23}$ in a powdered sample of sodium oxalate obtained without sample spinning.

Figure 14(b) is an NMR spectrum of $Na^{23}$ in a powdered sample of sodium oxalate obtained with spinning at the magic angle.

Figure 14(c) is an NMR spectrum of $Na^{23}$ in a powdered sample of sodium oxalate obtained by using the apparatus shown in Figure 4.

Figure 15 is a another embodiment of an apparatus according to the present invention.

## SUMMARY OF THE INVENTION

According to the present invention, the above objects are achieved by an apparatus for measuring the NMR spectra of a sample, said apparatus comprising means for holding said sample in a static magnetic field, the orientation of said sample with respect to the direction of said static magnetic field being specified by a polar angle $\theta$ and an azimuthal angle $\phi$; orientation means for causing the orientation of said sample to change relative to said static magnetic field, the orientation of said sample at time t being equal to a polar angle $\theta(t)$ and an azimuthal angle $\phi(t)$, wherein the orientation means is arranged to change the orientation of said sample with respect to said static magnetic field so that the time average of each of two sets of spherical harmonic functions $Y_{km}(\theta(t),\phi(t))$ for m = -k to +k and $Y_{jn}(\theta(t),\phi(t))$ for n = -j to +j is zero, wherein k is different from j and both k and j are different from zero.

Moreover, the above objects are achieved by a method of measuring the NMR spectra of a sample, said method comprising the steps of placing said sample in a static magnetic field, the orientation of said sample with respect to the direction of said static magnetic field being specified by a polar angle $\theta$ and an azimuthal angle $\phi$; causing the orientation of said sample to change relative to said static magnetic field, the orientation of said sample at time t being equal to a polar angle $\theta(t)$ and an azimuthal angle $\phi(t)$, which is characterized by the step of changing the orientation of said sample with respect to said static magnetic field so that the time average of each of two sets of spherical harmonic functions $Y_{km}(\theta(t),\phi(t))$ for m = -k to +k and $Y_{jn}(\theta(t),\phi(t))$ for n = -j to +j is zero, wherein k is different from j and both k and j are different from zero.

In particular, the present invention comprises an apparatus for measuring the NMR spectra of a sample. The sample is placed in a sample holder in a magnetic field. The sample holder is then moved over a trajectory for which the average values of two or more sets of spherical harmonic functions is substantially zero.

In one embodiment of the invention, as claimed in claims 3 to 6 and 15 to 18, this is accomplished by spinning said sample about a sample axis. The sample axis is then pivoted about a fixed end or point thereof between the first and second angles with respect to the direction of said magnetic field.

In a second embodiment of the invention, as claimed in claims 7 to 13 and 19 to 21, the sample is spun about the sample axis. The sample axis is then caused to sweep out a cone having an opening angle of $\theta_2$. The cone is inclined at an angle $\theta_2$ with respect to the magnetic field. Here, $\theta_1$ and $\theta_2$ are chosen such that the cosines of each angle is a zero of a Legendre polynomial.

In a third embodiment of the invention, as claimed in claims 2 and 22 to 24, the sample is "hopped" between each of a plurality of orientations.

DETAILED DESCRIPTION OF THE INVENTION

Under rapid isotropic reorientation, anisotropic nuclear interactions are averaged away. Rotation and diffusion motions in liquids and collisions in gases are examples of naturally occurring molecular motions which provide such averaging. Nuclear spins in solids or partially oriented samples, in contrast, are locked in constraining or partially constraining environments and do not enjoy the benefit of rapid isotropic orientational randomization. The NMR spectra of powdered solids thus exhibit broad, and frequently featureless, lines reflecting the effects of the anisotropies of the spin interactions.

Consider an orientationally disordered sample which is comprised of particles or regions (sets of particles) which are small crystals, fragments thereof, or molecules. In the NMR experiment, the sample is placed in a magnetic field having a predetermined direction. The frequencies of electromagnetic energy absorbed or emitted by each particle will depend on its orientation relative to the magnetic field. Since the sample contains a continuous range of particle orientations, a broad spectrum is observed. The broadness of this spectrum limits the usefulness of such measurements.

Ideally, one would like to measure similar properties with solid samples as are measured in liquid samples, namely, the NMR frequencies of each particle or region averaged over all possible orientations of that particle or region. Such an average is independent of the particle size and constitutes a sensitive measure of the underlying physical properties of the material being measured.

In principle, one can accomplish this by melting or dissolving the sample and measuring the sample in the liquid state. However, many samples of interest can not be studied in this manner.

A second prior art technique, referred to as magic angle spinning, provides a partial averaging motion analogous to the natural motions that provide averaging in liquids and gases. The apparent first order anisotropy of the nuclei in a rapidly spinning disordered sample depends on the angle between the direction of the external magnetic field and the axis about which the sample is spun. By choosing the proper angle, improvements in the observed line widths are achieved.

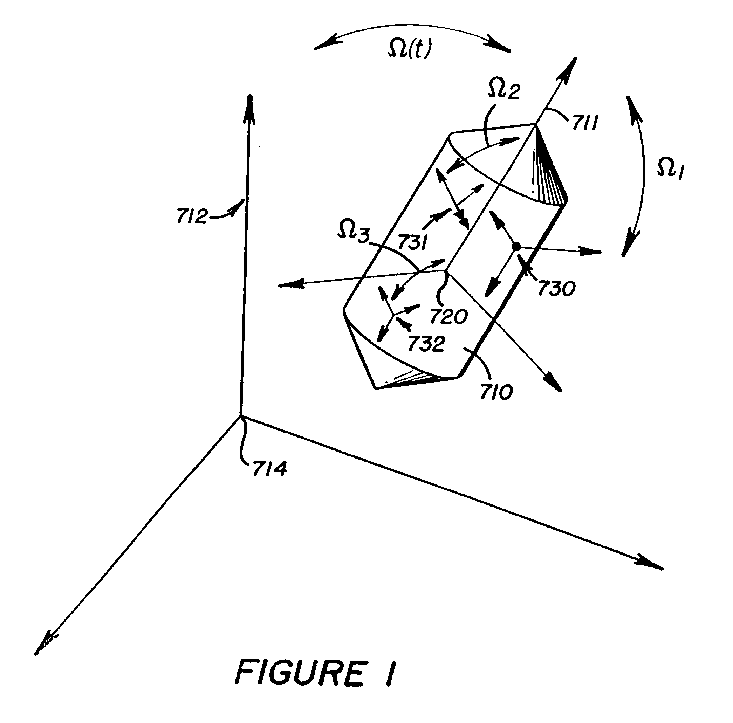

The manner in which the magic angle is chosen may be most easily understood with reference to Figure 1. A sample is placed in a sample holder 710 which is located in a magnetic field having the direction shown at 712. The magnetic field defines a first coordinate system having axes shown at 714. The sample holder may be described with reference to a second coordinate system shown at 720. At any given time, the angular relationship of this coordinate system with respect to the first coordinate system 714 may be specified by giving the values of a set of angles $\Omega$. As sample holder 710 moves, $\Omega$ changes with time. The manner in which $\Omega$ changes is specified by a function, $\Omega(t)$.

Within the sample holder, each particle or region of the sample has its own orientation which may be specified by a coordinate system associated with that particle or region. Exemplary particle coordinate systems are shown at 730-732. Each of the particle coordinate systems may be specified with respect to coordinate system 720 by giving the values of a set of angles $\Omega$. Particle coordinate system 730 is specified by $\Omega_1$; particle coordinate system 731 is specified by $\Omega_2$, and particle coordinate system 732 is specified by $\Omega_3$. It should be noted that $\Omega_1$, $\Omega_2$, and $\Omega_3$ are constants whose values are fixed once the sample is placed in sample holder 710.

Each set of angles, $\Omega$, consists of three angles, $\alpha$, $\Theta$ and $\phi$, which specify the angles between the two relevant coordinate systems.

It may be shown that, to a good approximation, the NMR frequencies emitted by the ith particle or region due to secular interactions up to rank L in the sample are given by

$$w(\Omega_i, \Omega(t)) = w_0 + \sum_{p=1}^{L} \sum_{m=-p}^{p} A_{pm}(\Omega_i) Y_{pm}(\Omega(t)) \qquad (1)$$

Here, the values of $A_{pm}$ depend on $\Omega_i$ and the chemical properties of the sample. The functions $Y_{pm}$ are the generalized spherical harmonic functions of rank p. For each rank p, there is a set of 2p+1 such functions. That is, m takes on the values from -p to +p. These functions depend only on two angles, the angle between the sample axis and the magnetic field direction and the angle between the projection of the magnetic field direction in the xy-plane and the x-axis of the sample related frame.

For the purposes of this discussion,

$$D_i = \sum_{p=1}^{L} \sum_{m=-p}^{p} A_{pm}(\Omega_i) Y_{pm}(\Omega(t)) \quad (2)$$

will be referred to as the frequency dispersion due to secular interactions contributed by the ith particle or region in the sample. The measured NMR signal is the sum of the signals emitted by each of the particles. Each particle contributes a constant set of frequencies $w_0$ to the spectrum and a frequency dispersion, $D_i$ which is different for each particle, since each particle has a different orientation.

The frequencies $w_0$ depend only on the chemical properties of the sample. Ideally, it is these frequencies that one would like to measure. However, these frequencies are masked by frequency dispersion terms which are different for different particles or regions. These terms give rise to the broad, often featureless, spectra observed for orientationally disordered samples.

When rotor 710 is spun sufficiently fast about its axis 711, the measured spectrum for the ith particle is the average of the spectrum given in Eq. (1), the average being taken over the range of $\Omega(t)$ angles realized by the spinning motion. Hence, the contribution of the ith particle becomes

$$<w(\Omega_i,\Omega(t))> = w_0 + \sum_{p=1}^{L} \sum_{m=-p}^{p} A_{pm}(\Omega_i) <Y_{pm}(\Omega(t))> \quad (3)$$

Here, <> denotes the average value of the quantity enclosed by the brackets. When rotor 710 is spun about axis 711, the average value of the generalized spherical harmonics, $<Y_{pm}(\Omega(t))>$, is zero for all m values other than 0. For m = 0,

$$<Y_{p0}(\Omega(t))> = P_p(\cos\Theta) \quad (4)$$

where $P_p$ denotes the Legendre polynomial of order p and e is the angle between the direction of the magnetic field and the axis of the sample holder, i.e., direction 712 and rotor axis 711.

Hence, when rotor 710 is spun about axis 711, the frequency dispersion contributed by each particle is given by

$$D_i = \sum_{p=1}^{L} B_p P_p(\cos\Theta) \quad (5)$$

Here, the $B_p$ are constants that depend on the properties of the sample.

In the case of magic angle spinning, e is chosen such that $P_2(\cos\Theta)$ is zero, i.e., $\Theta = 54.7$ degrees. Spinning a sample at the magic angle described above thus eliminates so-called first order line broadening. First order line broadening effects are proportional to the $P_2$ term, and correspond primarily to chemical shift anisotropy, secular dipolar interactions, and first order quadrupole interactions.

The approach just described leads to a significant reduction in observed line widths only when the $P_2$ term in Eq. (5) is the major contributor to the frequency dispersion. This is the case for NMR measurements based, for example, on $C^{13}$, $Si^{29}$, and $P^{31}$.

Unfortunately, many cases of interest do not satisfy this constraint. For example, both the $P_2$ and $P_4$ terms are significant for $B^{11}$, $O^{17}$, $Na^{23}$, and $Al^{27}$. These cases correspond primarily to second order quadrupole broadening. Broadening due to second order dipole - dipole interactions and susceptibility anisotropy can also contribute to the observed frequency dispersion in magic angle spinning of the spin one half nuclei, e.g., $C^{13}$ mentioned above. When such physical effects are present, more than one of the Legendre polynomials are important. Although spinning the sample at the magic angle provides some improvement in these cases, the resultant spectra are still too broad to provide all the data sought in NMR measurements based thereon.

A method for improving the poor resolution of NMR spectra for orientationally disordered systems which has been suggested in the prior art is to increase the magnetic field strength. It can be shown that the resolution of an NMR measurement which is limited by second order broadening increases as the magnetic field is increased. Unfortunately, unrealistically high magnetic fields are often required to remove the line broadening observed with powders.

When two or more terms in the Legendre expansion are significant, some additional improvement can be obtained by adjusting the spin angle empirically to minimize the observed frequency dispersion. However, if more than one term in the Legendre expansion is important, the frequency dispersion is often still too large to provide useful data.

The present invention provides a major reduction in frequency dispersion even when two or more of the terms in Eq. (5) are significant. The present invention utilizes a more complex pattern of motion so as to enable a more averaged measurement of the frequency of electromagnetic energy absorbed or emitted by each particle in an orientationally disordered sample. Magic angle spinning only averages the frequencies over a limited range of sample orientations. Hence, it does not provide the same resolution as that obtained in liquids where the averaging is performed over all possible orientations of each particle or region of the sample with respect to the direction of the magnetic field.

The present invention provides improved line widths by utilizing an $\Omega(t)$ having the property that the average value of each of the spherical harmonic functions in two sets of said spherical harmonics is zero for all m values. That is, the sample holder 710 is caused to move such that $\Omega$ becomes a function of time, $\Omega(t)$, where $\Omega(t)$ satisfies

$$\langle Y_{pm}(\Omega(t))\rangle = 0 \text{ for } m = -p \text{ to } +p \text{ and}$$

$$\langle Y_{qm}(\Omega(t))\rangle = 0 \text{ for } m = -q \text{ to } +q \tag{6}$$

Here, p is different from q, and both p and q are greater than zero. In the case in which line broadening due to second order dipole - dipole interactions and susceptibility anisotropy are to be eliminated, $p = 2$ and $q = 4$. However, it will be apparent to those skilled in the art that other values of p and q may be chosen to eliminate other second order line broadening.

A number of different paths, $\Omega(t)$, may be constructed such that Eq. (6) is satisfied. Three exemplary types of paths, corresponding to three different embodiments of the present invention, will be discussed below. However, it will be apparent to those skilled in the art that other paths may also be found which satisfy Eq. (6).

The first embodiment of the present invention may be more easily understood by first considering the manner in which the present invention would be used to measure an NMR spectrum if the apparatus could move the sample in a time which is short compared to the inverse of the NMR frequencies. The manner in which storage techniques can then be incorporated to remove this restriction will be discussed.

Consider a pattern of sample motion in which the sample is contained in a sample holder which "hops" between a plurality of orientations. Such a pattern can be described by a set of orientations $\Omega_i$ and a set of dwell times $T_i$. Here i runs from 1 to N where N is the number of orientations. The orientations $\Omega_i$ specify the angular orientation of the sample holder axis with reference to the direction of the applied magnetic field.

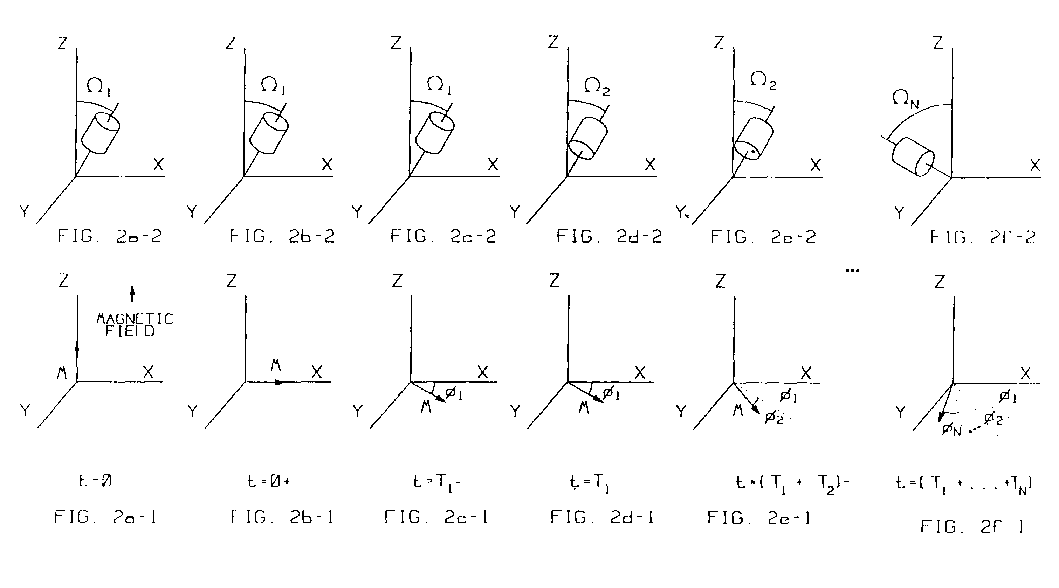

The orientation of the sample holder and the orientation of the polarization vector of the sample are illustrated in Figure 2 at various times during the experiment. Figure 2 consists of a number of pairs of drawings labeled (a) - (f). The top drawing in each pair of drawings illustrates the orientation of the sample holder with reference to the direction of the applied magnetic field. The bottom drawing of each pair illustrates the position of the magnetization vector of the sample with reference to the direction of the applied magnetic field. The applied magnetic field is assumed to be parallel to the z-axis in each of the drawings.

Figure 2(a) shows these positions at the beginning of the experiment, i.e., at time $t = 0$. At this time, the sample holder orientation is $\Omega_1$, and the magnetization vector, M, is along the z-axis. At $t = 0$ an RF pulse is applied to the sample which causes the magnetization vector to rotate about the y-axis such that it is located along the x-axis as shown in Figure 2(b), which illustrates the sample and M positions at $t = 0+$. The axis about which the M rotates is determined by the phase of the RF signal. In conventional NMR spectrometers, the RF coil is connected to a drive circuit which includes x and y inputs. The phase of the RF signal is specified by the ratio of the signals connected to said x and y inputs. For example, if a signal having only an x-component is inputted, M will rotate about the y-axis.

The position of the sample holder remains at $\Omega_1$ for a time $T_1$. During the course of the experiment, M precesses about the z-axis. By time $t = T_1-$, M will have precessed through an angle $\phi_1$ as shown in Figure 2(c). Here, the "-" signifies that the time in question is the instant just before $T_1$.

At $t = T_1$, the sample holder is "instantaneously" moved such that its new orientation is $\Omega_2$ as shown in Figure 2 (d). The sample holder remains at $\Omega_2$ for a time interval $T_2$. During this time interval, the magnetization vector, M, continues to precess. By $t = (T_1+T_2)-$, M will have precessed through a further angle $\phi_2$ as shown in Figure 2(e). At t

= $(T_1+T_2)$ The sample holder is again moved, this time to $\Omega_3$.

This process of hopping the sample holder at the end of each time interval is repeated until the sample holder has been moved to $\Omega_N$ and a time interval $T_N$ has elapsed. At this point, the position of the sample holder and magnetization vector will be as shown in Figure 2(f). The magnetization vector will have precessed through an angle $\phi = \phi_i+\phi_2+...+\phi_N$.

The position of the magnetization vector at the end of the experiment may be determined by measuring the signal in the RF coil. This signal is outputted from the same x and y inputs used to pulse the sample at the beginning of the experiment. The x and y signals so measured are proportional to $M\cos(\phi)$ and $M\sin(\phi)$, respectively. These outputs will be referred to as the x and y outputs, respectively.

It is known to those skilled in the NMR arts that

$$\phi = w_0 T \tag{7}$$

where $T = T_1+T_2+...+T_N$. In an apparatus and method according to the present invention, the $\Omega_i$'s and $T_i$'s are chosen such that Eq. (6) is satisfied. This will be the case if

$$\sum_{i=1}^{N} T_i Y_{pm}(\Omega_i) = 0 \text{ for } m = -p \text{ to } +p \tag{8}$$

and

$$\sum_{i=1}^{N} T_i Y_{qm}(\Omega_i) = 0 \text{ for } m = -q \text{ to } +q$$

where p is different from q and both p and q are greater than 0. In the preferred embodiment of the present invention, p = 2 and q = 4. As noted above, the main contributions to the line broadening resulting from second order dipole - dipole interactions and susceptibility anisotropy are to be eliminated in this case.

For the case of p = 2 and q = 4, the minimum number of angles needed to satisfy Eq. (7) is 6. In this case, $T_1 = T_2 = ... = T_6 = T$. That is, equal dwell times are used at each sample orientation. The angles in question correspond to the orientations assumed by the sample axis if it were to point to each of the vertices of an icosahedron centered at the origin. The first orientation corresponds to the sample axis lying along the z-axis, i.e., the direction of the magnetic field. The remaining five orientations correspond to the sample axis being at an angle of 63.43 degrees with respect to the magnetic field direction. The orientations correspond to five equally spaced orientations on a cone having its axis coincident with the z-axis and an opening angle of 2.6343 degrees.

If $w_0$ were a constant, a single measurement of $\phi$ would be sufficient. However, if there is more than one line in the NMR spectrum, a series of different measurements must be made at different values of T. The complex function

$$e^{i\phi(T)} = \cos(\phi(T))+ i[\sin(\phi(T))] \tag{9}$$

is then constructed and the Fourier transform thereof taken. As is well known to those skilled in the NMR arts, the resultant Fourier transformed function is the NMR spectrum.

The above discussion assumed that the sample holder could be hopped between the various locations in a time which is short compared to the inverse of the NMR frequencies being measured. The cost of constructing such an instantaneous hopping apparatus is prohibitive. If the hopping times are long compared to this time, the magnetization vector, M, will have decayed to zero by the time the hop is completed. As a result, no signal will be present at the end of the experiment.

In an apparatus and method according to the present invention, the decay of the magnetization vector is avoided by effectively storing the magnetization vector during the time the sample holder is being moved between successive positions.

The method in which the present invention operates may be most easily understood with reference to a simple NMR experiment in which the sample holder hops between two discrete orientations $\Omega_1$ and $\Omega_2$, and the sample spends equal times at each angle. This NMR experiment will be used to illustrate how the sum of the angles through which the magnetization vector precesses is obtained. In the case of a single hop, two experiments are needed to measure $\phi T$ for each value of T.

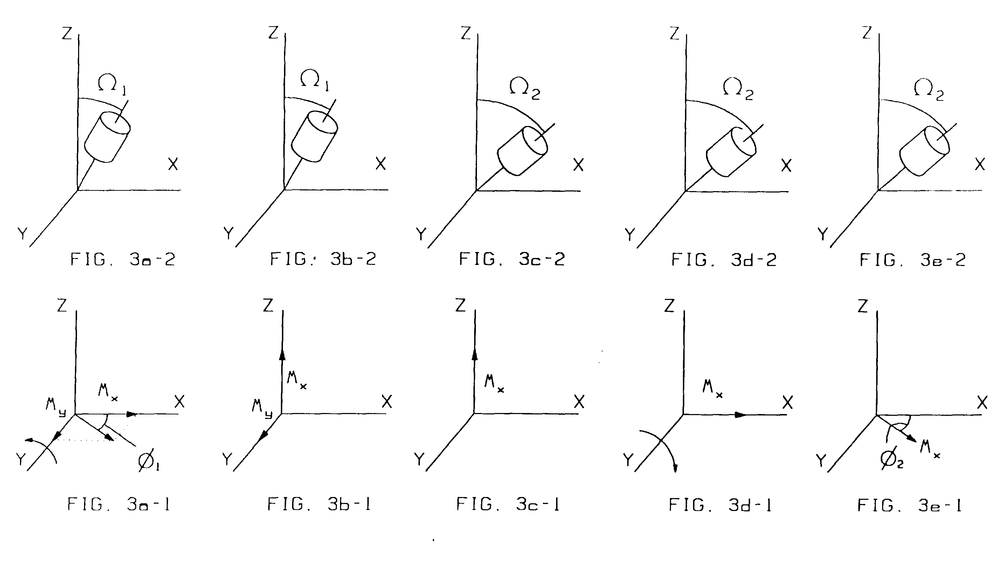

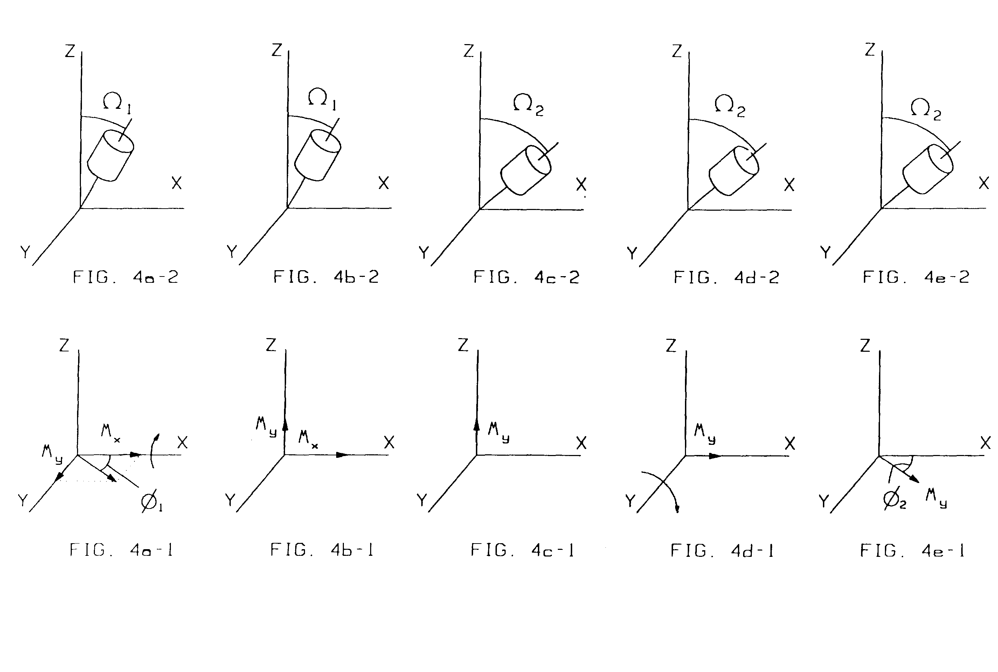

The manner in which these two experiments are combined to produce a measurement is most easily understood with reference to Figures 3 and 4. These figures are analogous to Figure 2 in that the top drawing shows the position of the sample holder, and the bottom drawing shows the position of the magnetization vector, M. Figure 3 illustrates the sample holder axis and magnetization vectors at various times during the first experiment. Figure 4 illustrates the sample holder axis and magnetization vectors at various times during the second experiment. The axes of the Cartesian coordinate system and direction of the applied magnetic field are the same as described with reference to Figure 2 above. At time t = 0 an RF pulse is applied to the sample which causes the magnetization vector, M, to tip such that it is now in the xy-plane. The RF pulse is applied by inputting separate x and y signals to the coil control circuit described above. The phase of the RF pulse is adjusted so that the magnetization vector M is initially along the x-axis.

After a time T elapses, M will have precessed through an angle $\phi_1$ as shown in Figure 3(a). The magnetization vector, M, may be decomposed into components $M_x$ and $M_y$ along the x and y axes, respectively. At this point in time, an RF signal is applied to the coil which causes the magnetization vector to rotate in space. The direction of this rotation is different for each of the experiments. The direction of the rotation is determined by the phase of the applied RF signal. In the first experiment, the axis of rotation is the y-axis. This is the same axis of rotation as that used to tip the magnetization vector away from the z-axis. Hence, a pulse having a phase which differs by 180 degrees from that of the original RF pulse is used. After this rotation, the component of the magnetization which was along the x-axis will now be along the z-axis as shown in Figure 3(b).

At this point in time, the sample holder is moved to $\Omega_2$. The motion takes a time which is long compared to the precession period of the magnetization vector. During this time, the component of the magnetization along the y-axis will have decayed to zero. However, the component along the z-axis will not have decayed because of the laws of quantum mechanics. Hence, after the sample has been moved to $\Omega_2$, the magnetization will be as shown in Figure 3 (c). That is, it will be along the z-axis and have a magnitude equal to that of $M_x$. Next, a third RF pulse is applied to the sample having a phase which is the same as the phase of the first RF pulse. This causes the magnetization to rotate 90 degrees around the y-axis such that it is now aligned with the x-axis as shown in Figure 3(d).

After a further time interval, T, elapses, the magnetization vector will have precessed through an angle $\phi_2$ as shown in Figure 3(e). The signals from the x and y outputs of the coil at this point in time will have magnitudes equal to $M_x\cos(\phi_2)$ and $M_x\sin(\phi_2)$, respectively. Since $M_x$ is equal to $M\cos(\phi_1)$, the x and y outputs will have signals equal to $M\cos(\phi_1)\cos(\phi_2)$ and $M\cos(\phi_1)\sin(\phi_2)$, respectively.

Figure 4 illustrates the sample axis and magnetization vectors at various times during the second experiment. At time t = 0 an RF pulse is applied as in the first experiment. The magnetization vector, M, after this pulse, lies along the x-axis as in the first experiment.

After a time T has elapsed, M will have again precessed through an angle $\phi_1$ as shown in Figure 4(a). At this point in time, an RF signal is applied to the coil which causes the magnetization vector to rotate about the x-axis. This is accomplished by applying an RF pulse which differs in phase by 90 degrees from that used to rotate the magnetization about the y-axis. After this rotation, the component of the magnetization which was along the y-axis will now be along the z-axis as shown in Figure 4(b).

The sample holder is then moved to $\Omega_2$. The movement takes a time which is long compared to precession period of the magnetization vector. During this time, the component of the magnetization along the x-axis will have decayed to zero, leaving only the component along the z-axis, as shown in Figure 4(c). A third RF pulse is then applied to the sample having a phase which is the same as the phase of the first RF pulse. This causes the magnetization to rotate 90 degrees around the y-axis such that it is now aligned with the x-axis as shown in Figure 4(d). The magnitude of the magnetization vector will now be $M_y$.

After a further time interval, T, has elapsed, the magnetization will have precessed through an angle $\phi_2$ as shown in Figure 4(e). The signals from the x and y outputs of the RF coil at this point in time will have magnitudes equal to $M_y\cos(\phi_2)$ and $M_y\sin(\phi_2)$, respectively. Since $M_y$ is equal to $M\sin(\phi_1)$, the x and y outputs will have signals equal to $M\sin(\phi_1)\cos(\phi_2)$ and $M\sin(\phi_1)\sin(\phi_2)$, respectively.

If one sums the x outputs from the two experiments, one obtains

$$M\cos(\phi_1)\cos(\phi_2) + M\sin(\phi_1)\cos(\phi_2) = M\cos(\phi_1+\phi_2) \qquad (10)$$

Similarly, the sum of the y outputs is

$$Mcos(\phi_1)sin(\phi_2) + Msin(\phi_1)sin(\phi_2) = Msin(\phi_1+\phi_2) \tag{11}$$

Given this background, the manner in which storage experiments may be used to calculate $e^{i\phi}$ where

$$\phi = \sum_{i=1}^{N} \phi_i$$

will now be discussed. If N orientations $\Omega_i$, are needed to satisfy Equation (8), then N-1 changes in position will be needed. At each change in position, either the x or y component of the magnetization vector as it existed just prior to the change in position can be stored. Hence, any given storage experiment can be specified by specifying the component of the magnetization vector which was stored prior to each of the changes in position.

At the end of each possible storage experiment, i.e., after the sample has spent a time $T_N$ at $\Omega_N$, the signals from the x and y outputs of the RF coil are measured. The signal from the x output will be

$$\prod_{i=1}^{N} F_i(\phi_i) \cos(\phi_N) \tag{12}$$

and the signal from the y output will be

$$\prod_{i=1}^{N} F_i(\phi_i) \cos(\phi_N) \tag{13}$$

where $F_i(x) = cos(x)$ if the x-component of the magnetization vector was stored at the ith position change, and $F_i(x) = sin(x)$ if the y-component of the magnetization was stored at the ith position change. Since there are N-1 changes in position, there are $2^{N-1}$ possible storage experiments in which each experiment produces two terms of the type shown in Equations (12) and (13). Hence, by performing all of the possible storage experiments, all terms of the form

$$\prod_{i=1}^{N} F_i(\phi_i),$$

where $F_i$ is either a sine or cosine, can be measured.

It will be apparent to those skilled in the mathematical arts that $e^{i\phi}$ can be expanded as follows:

$$e^{i\phi} = \sum_{i=1}^{N'} R_i \prod_{j=1}^{N} {}^{i}F_j(\phi_i) \tag{14}$$

where ${}^{i}F_j$ is either a sine or a cosine and the $R_i$ terms are constants. There are $2^N$ terms in equation (14). These are precisely the $2^n$ terms obtained from the various storage experiments. Hence, by performing all possible storage experiments, one can obtain the value of $e^{i\phi}$. If $e^{i\phi}$ is then measured for different values of T, and the Fourier transform thereof taken, the desired NMR spectrum can be determined.

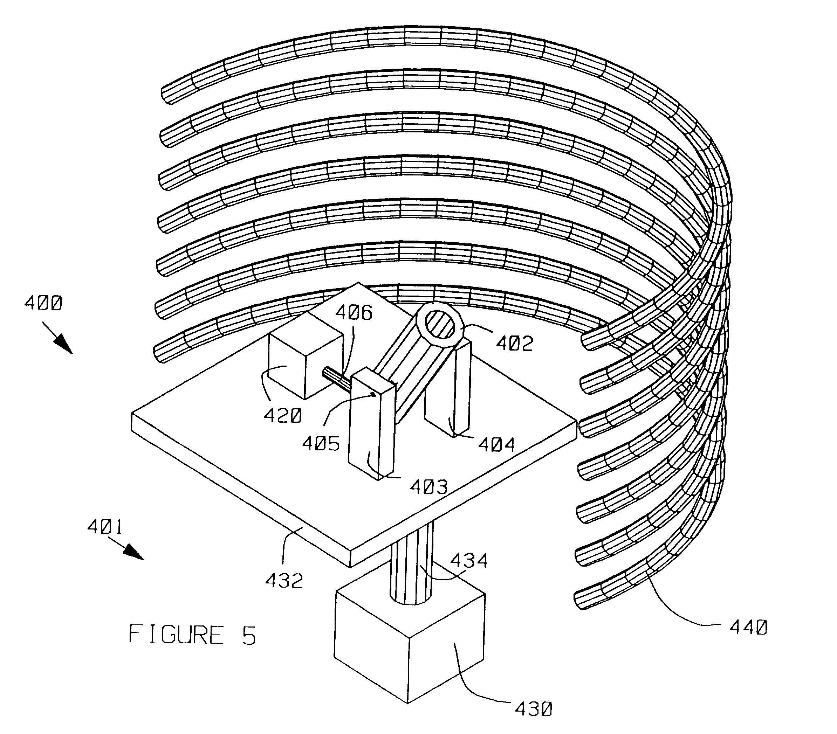

An apparatus for accomplishing the positional changes described above is illustrated in Figure 5 at 400. Apparatus 400 is placed in a constant magnetic field having a direction shown at 401. For simplicity, the magnet used for generating this magnetic field has been omitted from the drawing.

The material to be studied is placed inside sample holder 402. Sample holder 402 is mounted between supports 403 and 404 such that it is free to move about pin hinge 405. The angle between the axis of sample holder 402 and the magnetic field direction is controlled by a first actuator 420 which is hingedly connected to the bottom of sample holder 402 by rod 406. Actuator 420 is preferably a pneumatically operated linear actuator.

The orientation of sample holder 402 relative to the x and y axes is controlled by a second actuator shown at 430. Supports 402 and 403 are mounted on a table 432 which is in turn mounted on shaft 434. Actuator 432 is used to rotate table 432 about shaft 434 which determines the orientation of sample holder 402 relative to the x and y axes.

The sample holder 402 is located within RF coil 440. A portion of RF coil 440 has been cut away for clarity. Although RF coil 440 is shown in a fixed position relative to sample holder 402, it will be apparent to those skilled in the art that RF coil 440 could be replaced by a coil surrounding sample holder 402 and moving therewith. Such a coil would provide increased signal to noise ratio. If such a coil were used, the signals therefrom would need to be corrected for the change in coil orientation during the experiment.

The second and third exemplary embodiments of the present invention spin the sample about an axis while causing the axis in question to move in a predetermined manner. In the second embodiment, the axis moves in a plane.

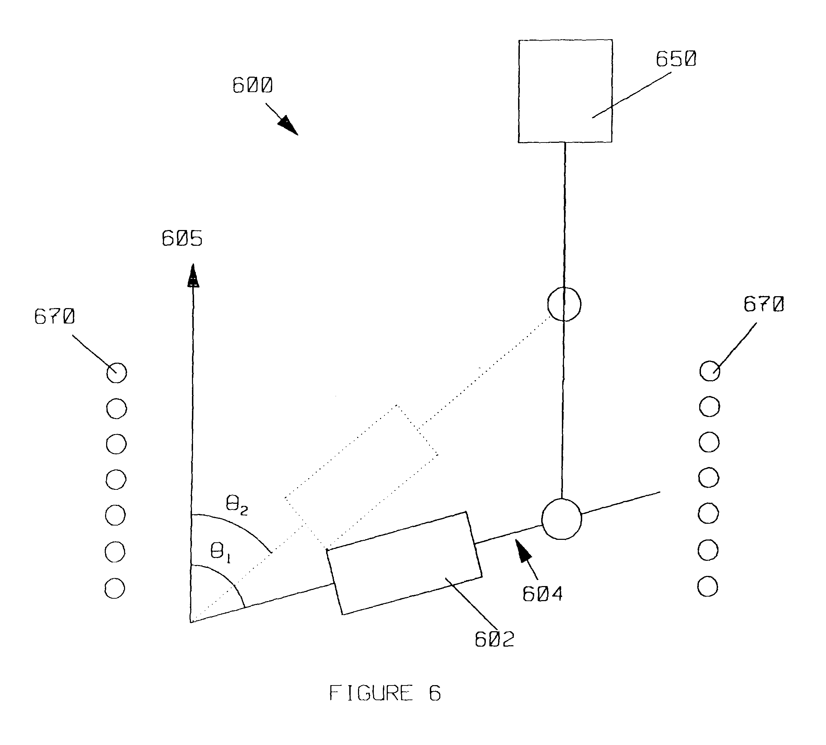

A cross-sectional view of an apparatus for providing the motion utilized in the second embodiment is illustrated in Figure 6 at 600. The sample is placed in a sample holder 602 which spins about an axis 604. Axis 604 is hinged such that it pivots between angles $\Theta_1$ and $\Theta_2$ with respect to the direction 605 of the magnetic field during the time period in which the NMR spectrum is measured. The pivoting is controlled by an actuator 606 which may be pneumatically driven. This pivoting apparatus differs from prior art NMR systems such as "variable angle spinning" or the prior art technique of two-dimensional correlation experiments in that the pivoting parameters are chosen so as to eliminate the contributions of two or more Legendre polynomials by moving the sample during the time the NMR spectra are being measured. In contrast, in variable angle spinning, the angle of the axis about which the specimen spins is fixed during the time the spectrum is measured.

The sample is excited by an RF pulse through a coil such as coil 607. In the following discussion, it will be assumed that the coil is fixed relative to the magnetic field. However, embodiments in which the coil is fixed relative to the holder 602 will be apparent to those skilled in the NMR arts. The latter arrangement has the advantage of requiring lower power RF signals and higher power detected signals. If such an arrangement is used, however, the signals must be corrected for the angular position of the sample holder. Such corrections are avoided if the coil remains fixed.

The pivoting motion can be accomplished by moving axis 604 using a suitable mechanical mechanism. Such mechanisms are included in many NMR spectrometers where they are used to adjust the angle of spinning of the sample. The motion of the axis is such that said axis is confined to a plane. By choosing $\Theta_1$, $\Theta_2$, and the manner in which the axis pivots, the contributions to the frequency dispersion resulting from two or more terms in Eq. (5) may be eliminated.

In the general case, the following condition must be satisfied to eliminate $P_n$:

$$\int P_n(\cos\Theta)\,W(\Theta)\,d\Theta = 0 \tag{15}$$

where $W(\Theta)$ is proportional to the time spent at each angle $\Theta$, and the integral is over the realized values of $\Theta$. As will become apparent from the following discussion, a total time of 2T is spent at the various angles where

$$\int W(\Theta)\,d\Theta = 2T \tag{16}$$

A sinusoidal motion for axis 604 is particularly easy to implement. For example,

$$\Theta(t) = \Theta_1 + (\Theta_2 - \Theta_1)\cos(\alpha t) \tag{17}$$

where $\alpha$ is a constant. In this case, it can be shown that the $P_2$ and $P_4$ terms can be eliminated if $\Theta_1 = 23.27$ degrees and $\Theta_2 = 117.37$ degrees.

If more than two terms in Eq. (5) are to be eliminated, one must introduce correspondingly more free parameters into Eq. (14). This may be accomplished by utilizing motions which are more complex than the linear or sinusoidal motions described above. For example, axis 604 could be programmed to make discrete "flips" between N discrete angles, $\Theta_i$, where i runs from 1 to N. In this case, $W(\Theta)$ would be the sum of a number of delta functions. That is, $W(\Theta)$ would be zero except when $\Theta$ was equal to $\Theta_i$, for some value of i between 1 and N. The values of the $\Theta_i$ and $W(\Theta)$ would be determined such that the desired terms in Eq. (5) are eliminated. For example, in the case of discrete flips between two angles $\Theta_1$ and $\Theta_2$ in which the rotor spends equal time at each angle, $W(\Theta_1) = W(\Theta_2) = T$, the

polynomials $P_2$ and $P_4$ can be eliminated with $\Theta_1 = 37.38$ degrees and $\Theta_2 = 79.19$ degrees. If $\Theta_1 = 39.23$ degrees, $\Theta_2 = 90$ degrees and $W(\Theta_1) = 1.25 \, W(\Theta_2)$, then the contributions to Eq. (5) from the three Legendre polynomials $P_2$, $P_3$, and $P_4$ can be eliminated simultaneously.

The above flipping must be accomplished in a time which is short compared to the NMR time scale. In general, this is difficult to accomplish with economically feasible mechanical mechanisms. The present invention overcomes this difficulty by utilizing storage techniques to effectively freeze the magnetization of the sample during the flips between the various locations. This allows more economical mechanical motions to be used; however, it increases the complexity of the experimental protocol.

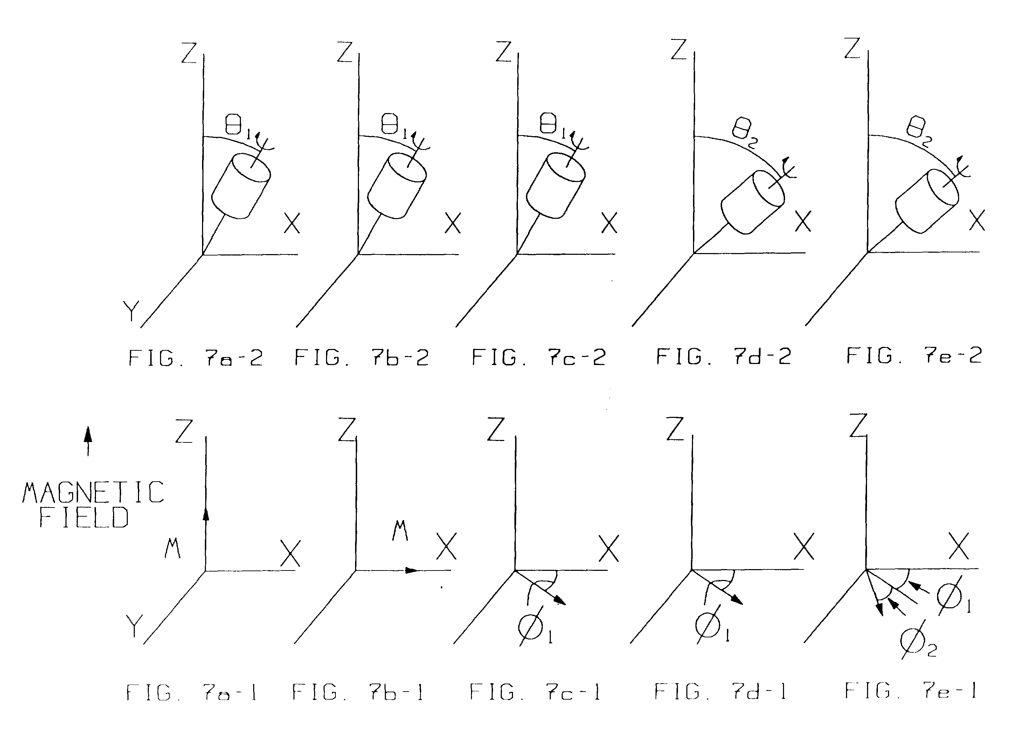

The method used to accomplish this motion utilizes storage techniques similar to those discussed above with reference to Figures 3 and 4. Consider the case in which the axis flips instanteously between two discrete angles $\Theta_1$ and $\Theta_2$, and the sample spends equal times at each angle. Figure 7 illustrates the positions of the sample and the positions of the magnetization vector during a single NMR measurement. The each of the upper drawings in Figure 7 illustrate the sample position, and the lower drawing illustrates the position of the magnetization. In the following discussion, it will be assumed that the applied magnetic field is along the z-axis of a Cartesian coordinate system which is shown in the lower part of Figure 7(a). The initial position of the sample is shown in the upper part of Figure 7(b). The magnetization of the sample initially will also be along this z-axis. At the beginning of the experiment an RF pulse is applied to the sample utilizing the coil 607.

The RF pulse causes the magnetization of the sample to tip such that it is perpendicular to the z-axis. The position of the magnetization vector M after the RF pulse is shown in Figure 7(b). By adjusting the phase of the RF signal, the magnetization of the sample will be tipped such that it lies along the x-axis. The NMR frequency $w_0$ is the rate at which the magnetization vector precesses about the z-axis after it has been so tipped. It is this precession frequency that one wishes to measure.

After a time T elapses, the magnetization vector, M, will have rotated through an angle $\phi_1$ as shown in Figure 7 (b). The sample holder will still be spinning at an angle $\Theta_1$ with reference to the z-axis. At this point in time, the sample axis is instantaneously flipped to the second angle $\Theta_2$ as shown in Figure 7(d). After a second time interval of T has elapsed, M will have precessed through a further angle of $\phi_2$ as shown in Figure 7(e). The sum of $\phi_1$ and $\phi_2$ is equal to the average value of $w_0$ over the 2T time interval.

The value of this sum angle may be obtained from the phase of the RF signal detected in the coil which was originally used to excite the sample. After the sample has been excited by the RF pulse, the coil used to excite the sample is typically used to receive RF energy radiated by the sample. The magnitude and phase of this detected signal measures the projection of the magnetization in the xy-plane as that magnetization varies in response to the interactions within the sample. In the preferred embodiment of the present invention, the coil is connected to a circuit which provides an x-output and a y-output. The x-output is the magnitude of the signal times the cosine of the phase angle. The y-output is the magnitude of the signal times the sine of the phase angle. The RF signals used to tip the magnetization vector are also inputted through this coil and are likewise inputted through x and y inputs which are analogous to the outputs described above.

As noted above, if $w_0$ were a pure single frequency, a single measurement would be sufficient. However, in general, $w_0$ is a frequency spectrum with a number of discrete lines. Hence, the above described measurement must be repeated for different values of T, each measurement yielding one value for $\phi = \phi_1 + \phi_2$. The Fourier transform of the function $e^{i\phi}$ is then calculated. The resultant function is the conventional NMR spectrum for the sample. For a different choice of angles and/or polynomials to be eliminated, time slices $T_1$, $T_2$, ... $T_N$ may have a different ratio and assume increments proportional to that ratio.

As noted above, instantaneous flipping is difficult to achieve. In general, one wishes to flip the sample axis in a time which is so small that the magnetization vector, M, is the same before and after the "flip". Since it is difficult to move the sample in this short a time, the present invention operates by effectively freezing one component of the magnetization and thereby preventing it from changing during the time the sample axis is moving between $\Theta_1$ and $\Theta_2$. Storage techniques similar to those described above are utilized to freeze the component in question. In the simple two angle experiment described above, two experiments are performed for each time point. In each experiment a different component of the magnetization is frozen prior to flipping the sample axis. Data from these two experiments is then combined to calculate the value of $\phi$.

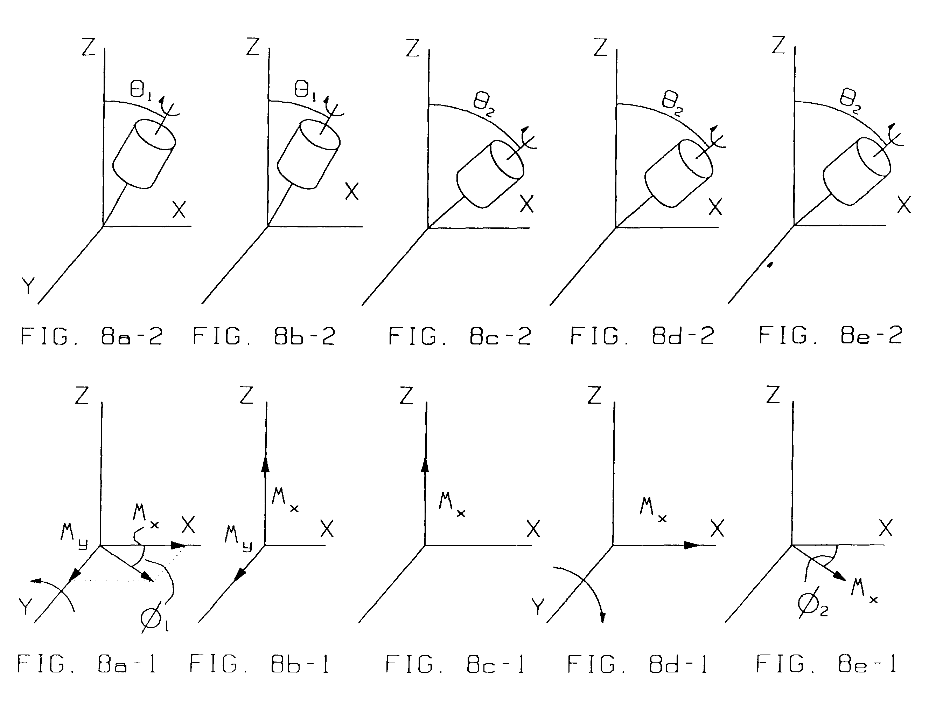

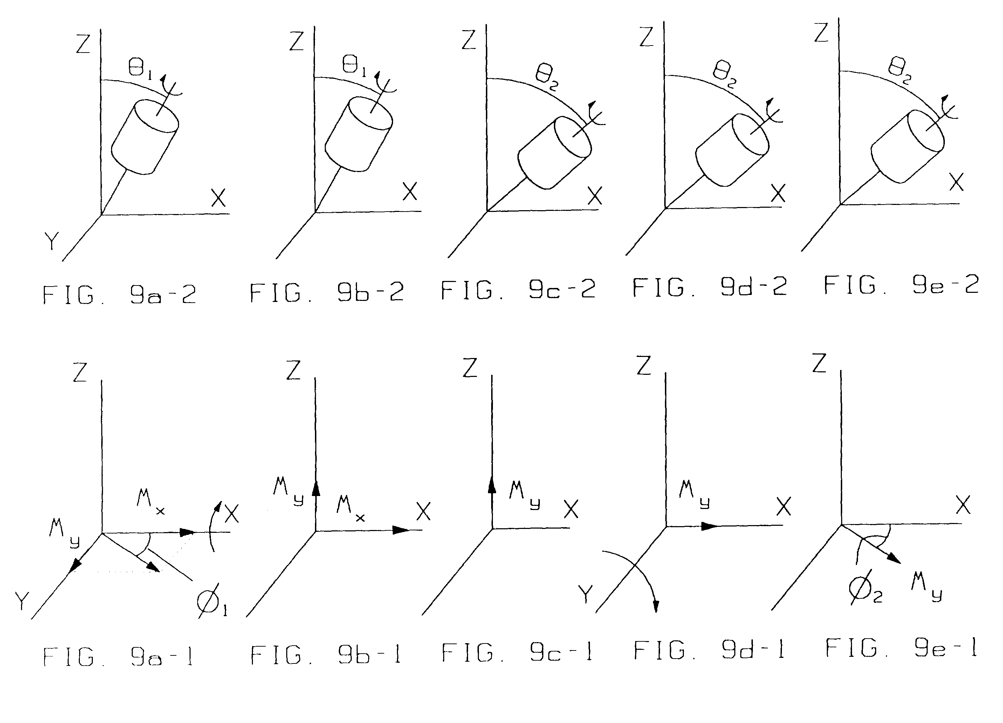

The manner in which these two experiments are combined to produce a measurement is most easily understood with reference to Figures 8 and 9. These figures are analogous to Figure 7 in that the top drawings show the position of the sample rotor, and the bottom drawings show the position of the magnetization vector, M. Figure 8 illustrates the sample holder axis and magnetization vector at various times during the first experiment. Figure 9 illustrates the sample holder axis and magnetization vector at various times during the second experiment. The axes of the Cartesian coordinate system and direction of the applied magnetic field are the same as described with reference to Figure 7 above. At time $t = 0$ an RF pulse is applied to the sample which causes magnetization vector, M, to tip such that it is now in the xy-plane. The RF pulse is applied by inputting separate x and y signals to the coil control circuit described above.

The phase of the RF pulse is adjusted so that the magnetization vector, M, is initially along the x-axis.

After a time T elapses, M will have rotated through an angle $\phi_1$ as shown in Figure 8(a). The magnetization vector may be decomposed into components $M_x$, and $M_y$ along the various x and y axes, respectively. At this point in time, an RF signal is applied to the coil which causes the magnetization vector to rotate in space. The direction of this rotation is different for each of the experiments. The direction of the rotation is determined by the phase of the applied RF signal. In the first experiment, the axis of rotation is the y-axis. This is the same axis of rotation as that used to tip the magnetization vector away from the z-axis. Hence, a pulse having a phase which is 180 degrees from that of the original RF pulse is used. After this rotation, the component of the magnetization which was along the x-axis will now be along the z-axis as shown in Figure 8(b).

At this point in time, the sample axis is flipped to $\Theta_2$. The flipping takes a time which is long compared to the precession period of the magnetization vector. During this time, the component of the magnetization along the y-axis will have decayed to zero. However, the component along the z-axis will not have decayed because of the laws of quantum mechanics. Hence, after the sample axis has been moved to $\Theta$ , the magnetization will be as shown in Figure 8(c). That is, it will be along the z-axis and have a magnitude equal to that of $M_x$. Next, a third RF pulse is applied to the sample having a phase which is the same as the phase of the first RF pulse. This causes the magnetization to rotate 90 degrees around the y-axis such that it is now aligned with the x-axis as shown in Figure 8(d).

After a further time interval of T, the magnetization will have precessed through an angle $\phi_2$ as shown in Figure 8 (e). The signal from the x and y outputs of the coil at this point in time will have magnitudes equal to $M_x\cos(\phi_2)$ and $M_x\sin(\phi_2)$, respectively. Since $M_x$ is equal to $M\cos(\phi_1)$, the x and y outputs will have signals equal to $M\cos(\phi_1)\cos(\phi_2)$ and $M\cos(\phi_1)\sin(\phi_2)$, respectively.

Figure 9 illustrates the sample axis and magnetization vector at various times during the second experiment. At time $t = 0$ an RF pulse is applied as in the first experiment. The magnetization vector, M, after this pulse lies along the x-axis as in the first experiment.

After a time T has elapsed, M will have again rotated through an angle $\phi_1$ as shown in Figure 9(a). At this point in time, an RF signal is applied to the coil which causes the magnetization vector to rotate about the x-axis. This is accomplished by applying an RF pulse which differs in phase by 90 degrees from that used to rotate the magnetization about the y-axis. After this rotation, the component of the magnetization which was along the y-axis will now be along the z-axis as shown in Figure 9(b).

At this point in time, the sample axis is flipped to $\Theta_2$. The flipping takes a time which is long compared to precession period of the magnetization vector. During this time, the component of the magnetization along the x-axis will have decayed to zero, leaving only the component along the z-axis, as shown in Figure 9(c). A third RF pulse is then applied to the sample having a phase which is the same as the phase of the first RF pulse. This causes the magnetization to rotate 90 degrees around the y-axis such that it is now aligned with the x-axis as shown in Figure 9(d). The magnitude of the magnetization vector will now be $M_y$.

After a further time interval of T, the magnetization will have precessed through an angle $\phi_2$ as shown in Figure 9 (e). The signal from the x and y outputs of the coil at this point in time will have magnitudes equal to $M_y\cos(\phi_2)$ and $M_y\sin(\phi_2)$, respectively. Since $M_y$ is equal to $M\sin(\phi_1)$, the x and y outputs will have signals equal to $M\sin(\phi_1)\cos(\phi_2)$ and $M\sin(\phi_1)\sin(\phi_2)$, respectively.

If one sums the x outputs from the two experiments, one obtains

$$M\cos(\phi_1)\cos(\phi_2) + M\sin(\phi_1)\cos(\phi_2) = M\cos(\phi_1+\phi_2) \qquad (18)$$

Similarly, the sum of the y outputs is

$$M\cos(\phi_1)\sin(\phi_2) + M\sin(\phi_1)\sin(\phi_2) = M\sin(\phi_1+\phi_2) \qquad (19)$$

After the above two experiments have been repeated for a number of different times T, the function

$$e^{i(\phi 1+\phi 2)} = \cos(\phi_1+\phi_2) + i\sin(\phi_1+\phi_2) \qquad (20)$$

is constructed and the Fourier transform of said function calculated. As pointed out above, the resultant function is the NMR frequency spectrum.

Although the above embodiment of the present invention utilized equal dwell times at the two angles, it will be apparent to those skilled in the art that different dwell times and angles may be utilized provided the time average of each of the two legendre polynomials is zero.

Similarly, the above embodiment of the present invention utilized RF pulses which caused the magnetization to be rotated about particular axes through 90 degrees. It will be apparent to those skilled in the art that other phase relationships may be utilized to determine the angle through which the magnetization precessed after the sample has spent the first time interval at the first angle and the second time interval at the second angle.

In addition, embodiments in which more than two angles are utilized will also be apparent to those skilled in the art. As noted above, such experiments allow the contributions of more than two of the Legendre polynomials to be eliminated. The number of storage experiments which must be carried out in this more general case is $2^{n-1}$, where n is the number of angles.

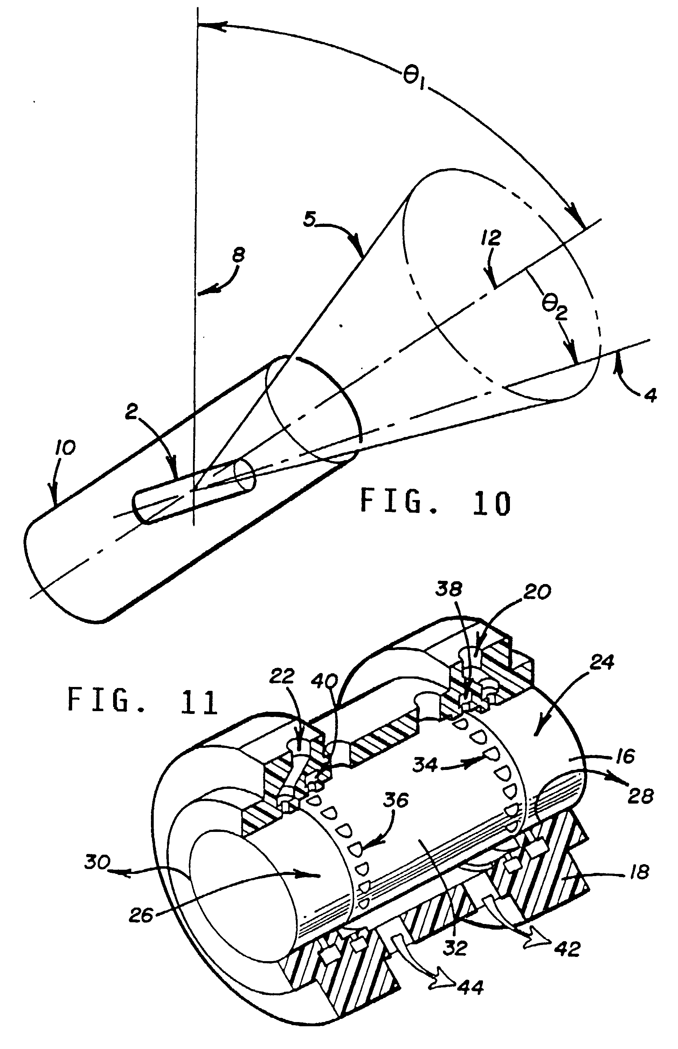

In the third embodiment of the present invention, these second order effects are overcome by rapidly spinning the sample about two axes. The basic spinning motion implemented in the preferred embodiment of the present invention is illustrated in Figure 10. A sample is placed in a sample holder 2 that spins about an axis 4 at an angular velocity of $w_1$. Sample holder p is then placed within a larger cylinder 10 that spins about a second axis 12 which spins at angular velocity of $w_2$. This larger cylinder 10 is inclined at an angle $\Theta_1$ with respect to the external magnetic field direction which is shown at 8. As a result of this motion, the axis 4 of sample holder 2 sweeps out a cone 5 having an opening angle of $\Theta_2$.

It may be shown that the resultant center band frequency dispersion due to secular interactions up to rank L observed when the sample is simultaneously spun about $\Theta_1$ and $\Theta_2$ is a function of products of Legendre polynomials:

$$D = \sum_{\rho=1}^{L} C_p \, P_p(\cos \Theta_1) \, P_p(\cos \Theta_2) \qquad (21)$$

Here, the $C_p$ are constants which depend on the chemical and physical properties of the sample.

For quadrupole and dipole-dipole broadening, it may be shown that only the terms for which p is an even number are significantly different from zero. Furthermore, the terms for which P is equal to two or four are the major contributors to the frequency dispersion in this case. Hence, in the preferred embodiment of the present invention, the angles are chosen such that

$$P_2 (\cos \Theta_1) = P_4 (\cos \Theta_2) = 0 \qquad\qquad (22)$$

Alternatively, $\Theta_1$ and $\Theta_2$ could be chosen such that

$$P_2 (\cos \Theta_2) = P_4 (\cos \Theta_1) = 0 \qquad\qquad (23)$$

Other frequency dispersion effects may be reduced by choosing $\Theta_1$ and $\Theta_2$ such that the Legendre polynomial terms which contribute most to these effects are zero.

The angular velocities, $w_1$ and $w_2$, must be sufficiently large to assure that the period of the rotational motion is small compared to the NMR relaxation times for the sample being measured. In addition, for reasons to be discussed below, certain integer ratios of $w_1$ and $w_2$ are preferably to be avoided.

In order to achieve these high spin rates, the present invention employs cylindrical objects that are suspended on air bearings and driven by air jets. Figure 11 illustrates the basic air bearing configuration. A cylinder 16 is held in an outer housing 18. The outer housing 18 has inlets 20 and 22 that enable pressurized air to enter, thereby suspending and "lubricating" cylinder 16 on air bearing surfaces 24 and 26 within the outer housing 18. Air exits from air bearings 24 and 26 via exit spaces between the outer housing 18 and the cylinder 16 which are shown at 28 and 30.

The central surface 32 of cylinder 16 is of a slightly different diameter than the outer surface. Impeller grooves 34 and 36 are cut into central surface 32. Cylinder 16 is made to rotate by applying pressurized air against the impeller grooves 34 and 36. The air that impinges upon impeller grooves 34 and 36 to drive cylinder 16 enters at orifices 38 and 40. The spent impeller drive air then exits the outer housing 18 through the orifices at 42 and 44.

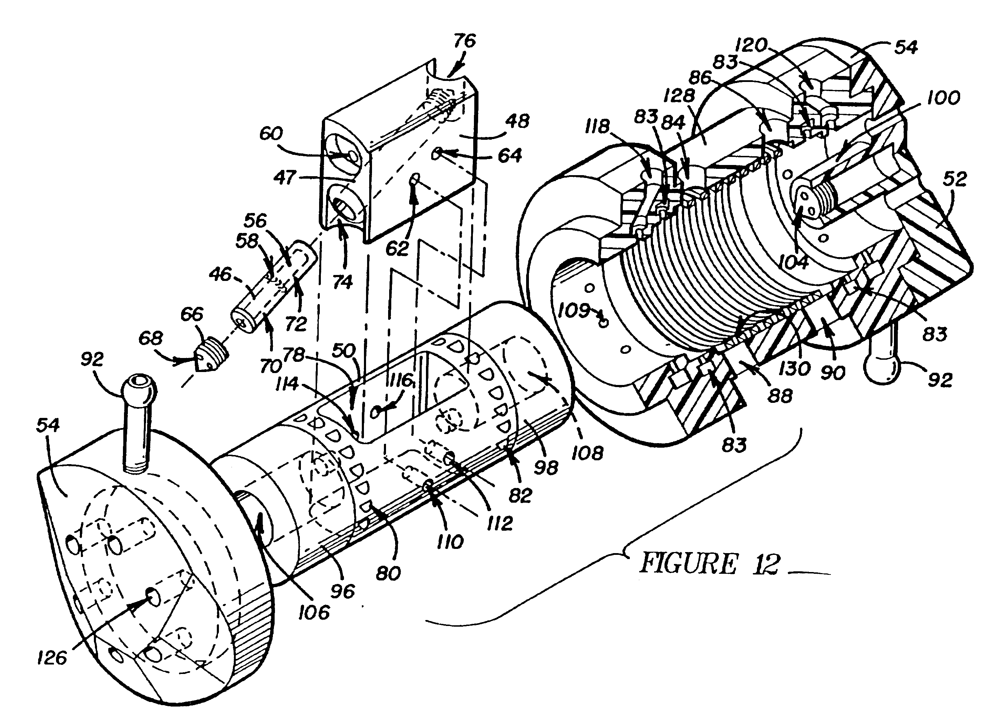

A combination of two simultaneously spinning systems is necessary to achieve the dual motion described in Figure 10. An apparatus for accomplishing this dual motion is shown in Figure 12. Essentially, the apparatus depicted in Figure 12 consists of five basic parts. The five parts are a sample holder 46, a first housing 48 that holds holder 46, a central cylinder 50 which in turn contains first housing 48, an apparatus housing 52, and end caps 54 (only one of which is depicted).

A sample of the material to be studied is placed into the center bore 56 of sample holder 46. Sample holder 46 includes a ring of notched impeller grooves 58 cut into the surface thereof. A stream of pressurized drive air impinging onto impeller grooves 58 causes sample holder 46 to spin in the manner described with reference to cylinder 16 shown in Figure 11. In a typical embodiment, sample holder 46 spins at 2000 Hz.

Sample holder 46 is inserted into chamber 47 in housing 48. Sample holder 46 is held in place by end caps 66 at each end of chamber 47. One of these end caps is hidden and hence not visible in the drawing.

Sample holder 46 is supported on air bearings which are implemented by suspending air bearing surfaces 70 and 72 with respect to two corresponding surfaces in chamber 47 of housing 48. The suspension mechanism is essentially that described with reference to Figure 11 above. Air is injected into the space between housing 48 and air bearing surfaces 70 and 72 through orifices in housing 48. The orifices are adjacent to said air bearing surfaces. The spent air from the air bearings exits housing 48 through orifices 68 in end caps 66.

The air utilized by the air bearings and drive mechanism enters the first housing 48 through two air entrance orifices 60, one on each end of first housing 48. One of the air entrance orifices 60 is not shown because it is hidden in the view shown in Figure 12. Housing 48 includes channels analogous to those shown in Figure 11 for routing the air from the entrance orifices 60 to the air bearing surfaces 70 and 72. Similarly, a channel in housing 48 routes the air to a location over impellers 58. The spent spin air from the impellers 58 is vented from the first housing 48 at the spin air exit orifices 62 and 64.

As noted above, sample holder 46 is inserted into the first housing 48 and held in place by two end caps 66 which include orifices 68. The spent air from air bearing surfaces 70 and 72 is exhausted primarily through the orifices 68 into concave grooves 74 and 76. Some of the air from air bearing surfaces 70 and 72 exits through air exit orifices 62 and 64.

First housing 48 fits into the central cavity 78 of central cylinder 50. First housing 48 is shaped such that when inserted in central cylinder 50, the outer surface of first housing 48 is congruent with the cylindrical surface of cylinder 50. Air exit orifices 62 and 64 are aligned with air exit orifices 110 and 112 in central cylinder 50 such that when first housing 48 is inserted in central cylinder 50, air exiting first housing 48 through air exit orifices 62 and 64 is routed to the surface of central cylinder 50 through air exit orifices 110 and 112.

Air exiting first housing 48 through orifices 68 in end caps 66 is also routed to the surface of central cylinder 50 through concave grooves 74 and 76 which form a passage between first holder 48 and the end walls of cavity 78. The passage allows air to leaving end caps 66 to reach the surface of central cylinder 50.

Pressurized air for the air bearings and drive mechanism in first housing 48 is supplied through the ends of central cylinder 50 via passages 106 and 108. As will be explained in more detail below, this air is injected into said passages 106 and 108 through protrusions 100 in end caps 54.

Central cylinder 50 has many features in common with first housing 48. Central cylinder 50 has two rings of notched impeller grooves 80 and 82 cut into the surface. Pressurized air applied against impeller grooves 80 and 82 causes central cylinder 50 to spin. Inlets for the pressurized impeller drive air are located at positions 118 and 120. Outlets for exiting impeller drive air 84, 86, 88 and 90 are found in device housing 52.

Central cylinder 50 is held within device housing 52 by two end caps 54. Each end cap 54 has an air inlet port 92 which is connected to a source of compressed air. Air inlet ports 92 are connected to hollow protrusions 100 which mate with passages 106 and 108 in central cylinder 50. The end 104 of each protrusion 100 includes orifices for allowing compressed air to flow into passage 106 which in turn provides air to air entrance orifices 60 in first housing 48.

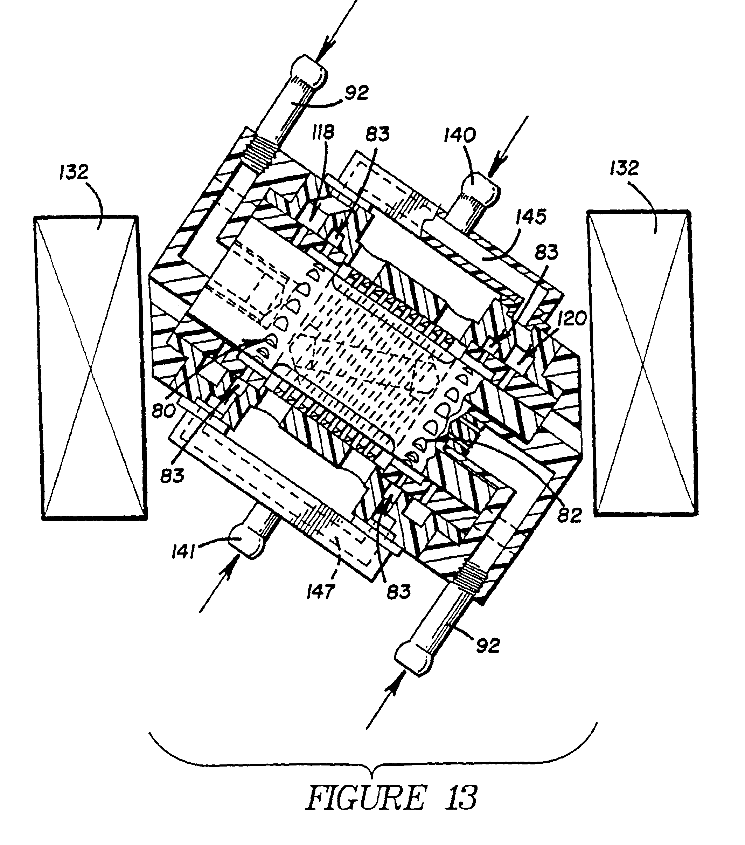

Central cylinder 50 is supported in device housing 52 on air bearings in a manner analogous to that described with reference to Figure 11. Central cylinder 50 includes air bearing surfaces 96 and 98 on the outer ends thereof. Air is injected into the space between air bearing surfaces 96 and 98 and the walls of device housing 52 through orifices 109 in the wall of device housing 52. The air used for this purpose is coupled to orifices 109 through channels in device housing 52. Two such channels are shown at 118 and 120. The channels in question are connected to a source of compressed air through an external manifold which will be explained in more detail with reference to Figure 13. Similarly, compressed air is directed against impellers 80 and 82 by connecting orifices 83 to a source of compressed air through a second manifold which will be discussed in detail with reference to Figure 13.

As mentioned above, spin air exits through orifices 62 and 64 of first housing 48 are directly aligned with exit orifices 110, 112, 114 (partially obscured) and 116 in central cylinder 50. Exit orifices 114 and 116 service a second set of spin air exits in first housing 48 which are obscured from view in Figure 12. Spent spinner air from holder 46 thus exits from spin air exits 62 and 64, and then through air exit orifices 110, 112, 114 and 116. This spinner air ultimately discharges from the apparatus through air outlets 84, 86, 88, and 90. Spent air emitted from first housing 48 via concave surfaces 74 and 76 also leaves the apparatus via air outlets 84, 86, 88, and 90. Spent air from the air bearings for central cylinder 50 exits through air ports 126 which are located in end caps 54.

The central portion 128 of device housing 52 is enlarged to accommodate detector coil 130. Detector coil 130 is used to detect RF frequencies during NMR measurements.

Figure 13 shows a cross section of the apparatus of the present invention positioned between the poles 132 of an external magnet. Compressed air is supplied through inlet ports 92 shown in Figure 13 and through two additional ports 140 and 141 which are connected to manifolds 145 and 147, respectively. Manifold 147 supplies air to inlets 83 which direct the air in question against impellers. Manifold 145 is connected to inlets 118 and 120 which supply air to suspend central cylinder 50 on its air bearing surfaces 96 and 98 as shown in Figure 12.

Referring again to Figure 12, central cylinder 50 spins at angular velocities $w_2$ which are several hundreds of revolutions per second. Hence, the forces applied to sample holder 46 can be quite large. These forces must be supported by the air bearings which support sample holder 46 in first housing 48.

These forces may be reduced by properly choosing the dimensions of sample holder 46. Sample holder 46 spins at speeds in excess of two thousand revolutions per second. Sample holder 46 is, in effect, a small gyroscope with its axis displaced from the vertical by angle $\Theta_2$ shown in Figure 10. As is known in the mechanical arts, a gyroscope so displaced will precess such that its axis sweeps out a cone at an angular velocity which depends on the moments of inertia of the gyroscope, $\Theta_2$ and $w_1$. It may be shown that the gyroscope will precess with an angular velocity $w_{nut}$ satisfying the following relationship:

$$w_1 = (I_{tr} - I_{ax}) w_{nut} \cos(\Theta_2)/I_{ax} \tag{24}$$

where $I_{tr}$ and $I_{ax}$ are transverse and axial moments of inertia of sample holder 46.

If the moments of inertia are chosen such that the desired value for $w_2$ is equal to the value of $w_{nut}$ given in Eq. (24), then sample holder 46 will precess at the desired $w_2$ value without any forces being applied through first housing 48. The moments of inertia in question depend on the radius and length of sample holder 46 which comprises a hollow cylinder. Hence, by choosing the proper radius and sample compartment size for any given length sample holder, the forces in question may be substantially reduced. The use of such gyroscopic precession will be discussed further with reference to an alternate embodiment of the present invention described below.

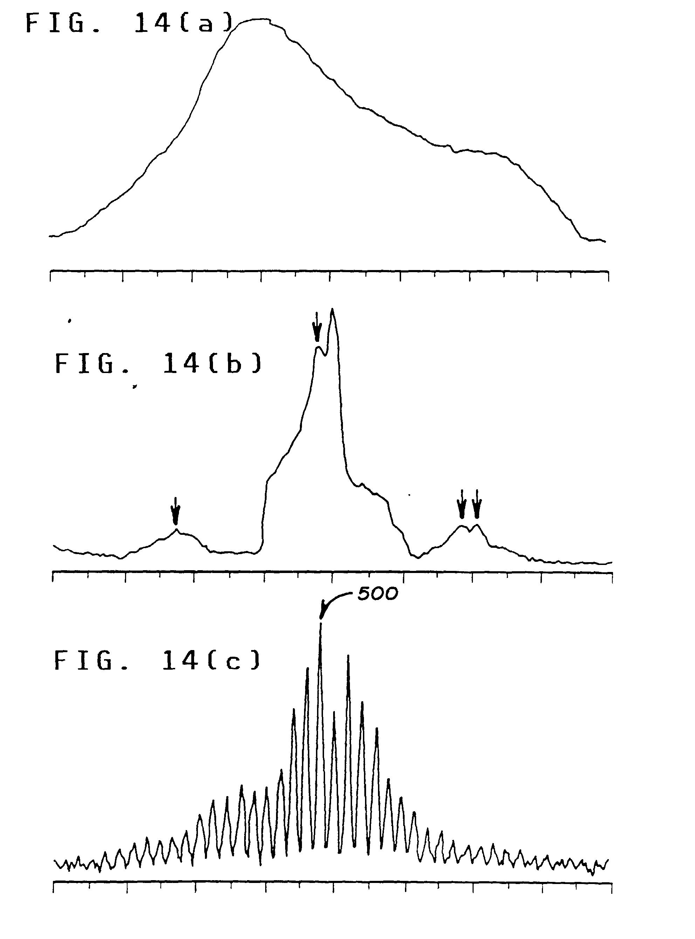

The dramatic improvement obtained with the present invention is illustrated in Figures 14(a) - 14(c) which show $Na^{23}$ NMR spectra for a powdered sodium oxalate sample taken with various apparatuses. Figure 14(a) is a spectrum obtained with the sample stationary. As can be seen from the figure, the resultant spectrum is quite broad and shows few features of interest.

Figure 14(b) is an NMR spectrum of the same sodium oxalate sample, but with the sample being spun at the magic angle. The peaks marked by the arrows in Figure 14(b) are side bands resulting from the modulation of the NMR signal by the rotation of the sample. Although the spectrum shown in Figure 14(b) displays a considerably narrower line for $Na^{23}$, the line width is still far from satisfactory.

Figure 14(c) is an NMR spectrum from the same sodium oxalate sample using the embodiment of the present invention shown in Figure 12. The sample holder 46 shown in Figure 12 was spun at 2000 Hz while central cylinder 50 was spun at 400 Hz. The values for $\Theta_1$ and $\Theta_2$ in Eq. (21) were chosen to be 54.7 degrees and 70.1 degrees, which correspond to zeros of $P_2 (\cos \Theta)$ and $P_4 (\cos \Theta)$. The $Na^{23}$ line is shown at 500. The remaining peaks are side bands resulting from the modulation of the signal from the $Na^{23}$ line. These side bands can be eliminated, for example, by spinning the sample at higher angular velocities or by side band suppression techniques analogous to those used in magic angle spinning. As can be immediately appreciated from these figures, the line width obtained with the present invention is dramatically smaller than that obtained using either of the two above mentioned prior art techniques.

The values of $\Theta_1$ and $\Theta_2$ in the above described embodiment of the present invention were chosen to eliminate effects arising from the $P_2$ and $P_4$ terms of Eq. (21). In the case of $Na^{23}$, these terms are the two main contributors to the line width. The line widths obtained with other nuclei may be the result of terms other than $P_2$ and $P_4$. It will be apparent from the above discussion that by choosing $\Theta_1$ and $\Theta_2$ such that $P_i(\cos \Theta_1) = 0$ and $P_j(\cos \Theta_2) = 0$, line broadening which results from any two terms depending on $P_i$ or $P_j$ in Eq. (21) can be eliminated by the above described embodiment of the present invention.

An apparatus according to the present invention can also be utilized for eliminating line broadening arising from three or more terms in Eq. (21). In the apparatus shown in Figure 12, the sample holder consists of a cylinder which spins about its axis. This cylinder is mounted in a second cylinder (central cylinder 50) such that the sample holder axis is inclined at $\Theta_1$ with respect to the axis of the second cylinder. The second cylinder then rotates at about its axis which is inclined at $\Theta_2$ with respect to the magnetic field direction.

This type of structure can be utilized for more complex motions. For example, an apparatus for eliminating three terms from Eq. (21) can be constructed by mounting central cylinder 50 shown in Figure 12 inside an outer cylinder such that the axis of central cylinder 50 is inclined at angle $\Theta_2$ with respect to the axis of the outer cylinder. The outer cylinder would then be spun at a third angular velocity about its axis which would be inclined at an angle $\Theta_3$ relative to the magnetic field direction. It may be shown that the frequency dispersion obtained in such an arrangement is a function of products of three Legendre polynomials:

$$D = \sum_{i=1}^{L} E_i P_i(\cos \Theta_1) \; P_i(\cos \Theta_2) \; P_i(\cos \Theta_3) \qquad (25)$$

One is free to chose the values of $\Theta_1$, $\Theta_2$, and $\Theta_3$. Hence, if $\Theta_1$, $\Theta_2$, and $\Theta_3$ are chosen such that

$$P_p(\cos \Theta_1) = P_m(\cos \Theta_2) = P_n(\cos \Theta_3) = 0 \qquad (26)$$

then the contributions to the line width of the terms depending on $P_p$, $P_m$, and $P_n$ can be eliminated.

It is apparent from the above discussion that, in principle, N terms can be eliminated by constructing a multiple spinning apparatus having N nested spinning cylinders, the sample being contained in the innermost cylinder. If the sample holding cylinder is labeled as 1, then the ith cylinder is mounted in the (i+1)st cylinder such that the axis of the ith cylinder is inclined at an angle $\Theta_i$ with respect to the axis of the (i+1)st cylinder for i = 1 to (N-1). The axis of the Nth cylinder is inclined at an angle $\Theta_N$ with respect to the magnetic field direction. The angles $\Theta_i$ are chosen such that the cosine of each angle is a zero of a different Legendre polynomial.

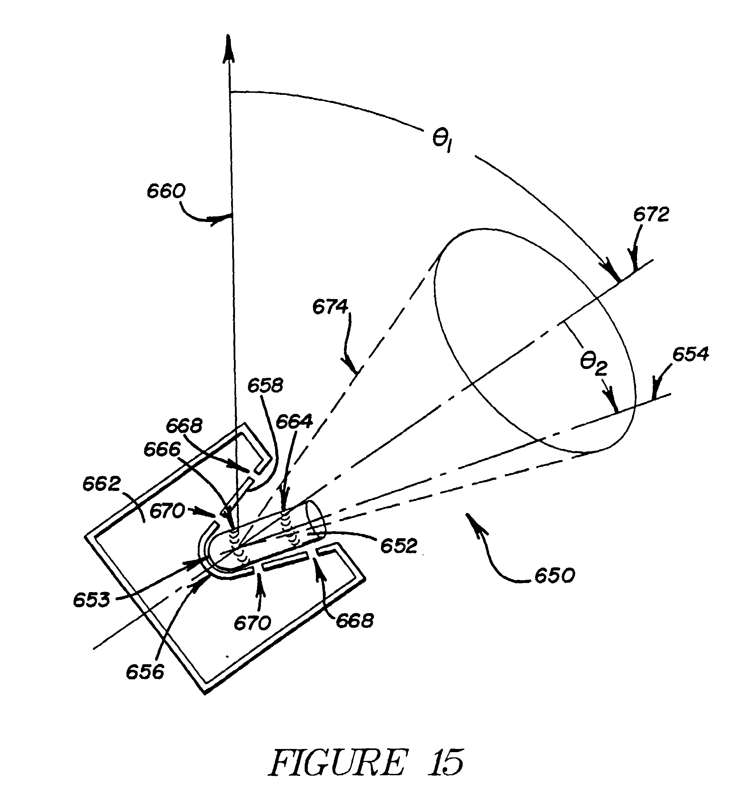

An alternative structure for implementing the third embodiment of the present invention is illustrated in Figure 15 at 650. The sample is placed in a sample holder 652 which spins about an axis 654. Sample holder 652 is a cylinder that has a rounded end as shown at 653. Sample holder 652 fits within the stationary stator 662 that is positioned between the poles of a magnet which creates an external magnetic field in direction 660. Stator 662 has a concave surface 656 that joins the inner frusto-conical surface 658 of stator 662 at one end. Rounded end 653 of sample holder 652 engages stator 662 at concave surface 656.

Axis 672 of stator 662 is inclined at angle $\Theta_1$ with respect to external magnetic field 660, and axis 654 is inclined at angle $\Theta_2$ from axis 672. Drive air from inlet ports 668 and 670 in stator 662 is made to impinge upon impellers 664 and 666 cut into the surface of sample holder 652. Air impinging upon sample holder 652 thus causes sample holder 652 to spin about axis 654 while simultaneously sweeping out the cone 674 around axis 672. Air impinging on sample holder 652 through inlet ports 670 also acts as an air bearing analogous to the air bearings described above.

Sample holder 652 is essentially a precessing gyroscope. The angular velocity at which axis 654 precesses about cone 674 is given by Eq. (24) discussed above.

By varying angles $\Theta_1$ and $\Theta_2$ of Figure 15 for particular species, frequency dispersion contributions from two Legendre polynomials can be eliminated.

Accordingly, there has been described herein a novel apparatus and method for performing NMR measurements. Various modifications to the present invention will become apparent to those skilled in the art from the foregoing description and accompanying drawings. Hence, the present invention is to be limited solely by the scope of the following claims.

## Claims

1. An apparatus for measuring the NMR spectra of a sample, said apparatus comprising:

    means (710) for holding said sample in a static magnetic field (712), the orientation of said sample with respect to the direction of said static magnetic field (712) being specified by a polar angle $\theta$ and an azimuthal angle $\phi$; orientation means (420) for causing the orientation of said sample to change relative to said static magnetic field (712), the orientation of said sample at time t being equal to a polar angle $\theta(t)$ and an azimuthal angle $\phi(t)$,

    **characterized in that**
    the orientation means is arranged to change the orientation of said sample with respect to said static magnetic field (712) so that the time average of each of two sets of spherical harmonic functions $Y_{km}(\theta(t),\phi(t))$ for m = -k to +k and $Y_{jn}(\theta(t),\phi(t))$ for n = -j to +j is zero, wherein k is different from j and both k and j are different from zero.

2. The apparatus of claim 1 wherein said orientation means comprises means (420, 430) for causing the orientation of said sample to assume a succession of discrete orientations relative to the direction (401) of said static magnetic field, the ith orientation being specified by a polar angle $\theta_i$ and an azimuthal angle $\phi_i$, with i running from 1 to N and the time spent at $\theta_i$ and $\phi_i$ being $T_i$, wherein

$$\sum_{i=1}^{N} T_i Y_{km}(\theta_i, \phi_i) = 0$$

for m = -k to +k and

$$\sum_{i=1}^{N} T_i Y_{jm}(\theta_i, \phi_i) = 0$$

for m = -j to +j.

3. The apparatus of claim 1 wherein said orientation means comprises: means for spinning said sample about a sample axis (604); and pivoting means (606) for causing said sample axis (604) to pivot about a fixed point thereof between first and second polar angles ($\theta_1$, $\theta_2$) with respect to the direction of said static magnetic field (605).

4. The apparatus of claim 3 wherein said pivoting means (606) further comprises means for causing said sample axis (604) to move at a constant angular velocity between said first and second polar angles ($\theta_1$, $\theta_2$).

5. The apparatus of claim 3 wherein said pivoting means (606) further comprises: means for causing said sample axis to dwell for a first time interval at said first polar angle ($\theta_1$); means for causing said sample axis (604) to move to said second polar angle ($\theta_2$); and means for causing said sample axis (604) to dwell for a second time interval at said second polar angle ($\theta_2$).

6. The apparatus of claims 3 wherein said pivoting means (606) further comprises means for causing said sample axis (604) to move between said first and second polar angles at an angular velocity which varies sinusoidally with time.

7. The apparatus of claim 1 wherein said orientation means comprises: means for causing said sample holding means (2) to spin about a sample axis (4); means for causing said sample axis (4) to sweep out a cone (5) having a predetermined opening angle ($\theta_2$), the axis of said cone (5) being inclined at a predetermined angle ($\theta_1$) to the direction of said magnetic field (8).

8. The apparatus of claim 7 wherein said sample holding means comprises a cylinder (46) having an axial moment of inertia, $I_{ax}$, and a transverse moment of inertia, $I_{tr}$, said means for causing said sample holding means to spin comprises means for causing said cylinder (46) to spin at an angular velocity of $w_1$ revolutions per second, and said means for causing said sample axis to sweep out a cone causes said axis to make one revolution on said cone every $1/w_{nut}$ seconds wherein $w_1$ is equal to $(I_{tr}-I_{ax})w_{nut}\cos(\theta_2)/I_{ax}$, $\theta_2$ being the angle of inclination of the axis of said cone relative to said magnetic field direction.

9. The apparatus of claim 7 wherein the cosine of said opening angle ($\theta_2$) is a zero of a first Legendre polynomial and the cosine of said angle of inclination ($\theta_1$) is a zero of a second Legendre polynomial.

10. The apparatus of claim 7 wherein said first Legendre polynomial has order 2 and said second Legendre polynomial has order 4.

11. The apparatus of claim 7 wherein said sample holding means (652) comprises a cylinder having a rounded end (653), said cylinder including impellers (664, 666) on the surface thereof, and wherein said means for causing said sample holding means to spin about a sample axis (654) comprises: a frusto-conical stator (662) having an axis inclined at said predetermined angle ($\theta_1$) with respect to said magnetic field direction (660) and an opening angle ($\theta_2$) equal to said predetermined opening angle, said stator (662) further including means for engaging said rounded end; and means for directing air jets against said impellers (664, 666).

12. The apparatus of claim 11 wherein said means for directing air jets comprises a plurality of inlet ports (670) in said stator.

13. The apparatus of claim 7 wherein said sample holding means comprises a first cylinder (46) having a compartment (56) therein for holding said sample, the axis of said first cylinder being coincident with said sample axis, wherein said means for causing said sample holding means to spin comprises means for causing said first cylinder to spin about the axis thereof, and wherein said means for causing said sample axis to sweep out a cone comprises a second cylinder (50) including means (47) for holding said first cylinder such that the axis of said first cylinder is inclined at said opening angle with reference to the axis of said second cylinder, the axis of said second cylinder being inclined at said angle of inclination with reference to said magnetic field direction; and means for causing said second cylinder (50) to spin about the axis thereof.

**14.** A method of measuring the NMR spectra of a sample, said method comprising the steps of:

placing said sample in a static magnetic field (712), the orientation of said sample with respect to the direction of said static magnetic field (712) being specified by a polar angle $\theta$ and an azimuthal angle $\phi$; causing the orientation of said sample to change relative to said static magnetic field (712), the orientation of said sample at time t being equal to a polar angle $\theta(t)$ and an azimuthal angle $\phi(t)$,

**characterized by the step of**
changing the orientation of said sample with respect to said static magnetic field (712) so that the time average of each of two sets of spherical harmonic functions $Y_{km}(\theta(t),\phi(t))$ for m = -k to +k and $Y_{jn}(\theta(t),\phi(t))$ for n = -j to +j is zero, wherein k is different from j and both k and j are different from zero.

**15.** The method of claim 14 wherein said step of causing said sample to move comprises: spinning said sample about a sample axis (604); and causing said sample axis to pivot about a fixed end thereof between first and second angles $(\theta_1, \theta_2)$ with respect to the direction of said magnetic field (605).

**16.** The method of claim 15 wherein said step of causing said sample axis to pivot further comprises causing said sample axis (604) to move at a constant angular velocity between said first and second angles $(\theta_1, \theta_2)$.

**17.** The method of claim 15 wherein said step of causing said sample axis (604) to pivot further comprises: causing said sample axis to dwell for a first time at said first angle $(\theta_1)$ ; causing said sample axis to move to said second angle $(\theta_2)$ ; and causing said sample to dwell for a second time at said second angle $(\theta_2)$.

**18.** The method of claim 15 wherein said step of causing said sample axis (604) to pivot further comprises causing said sample axis (604) to move between said first and second angles at an angular velocity which varies sinusoidally with time.

**19.** The method of claim 14 wherein causing said sample to move relative to said magnetic field comprises: causing said sample to spin about a sample axis (4); causing said sample axis (4) to sweep about a cone (5) having a predetermined opening angle $(\theta_2)$ , the axis of said cone (5) being inclined at a predetermined angle $(\theta_1)$ to the direction of said magnetic field (8).

**20.** The method of claim 19, wherein the cosine of said opening angle $(\theta_2)$ is a zero of a first Legendre polynomial and the cosine of said angle of inclination $(\theta_1)$ is a zero of a second Legendre polynomial.

**21.** The method of claim 20 wherein said first Legendre polynomial has order 2 and said second Legendre polynomial has order 4.

**22.** The method of claim 14 wherein causing said orientation of said sample relative to said static magnetic field comprises causing the orientation of said sample to assume a succession of discrete orientations relative to said magnetic field direction (401), the ith orientation being specified by a polar angle $\theta_i$ and an azimuthal angle $\phi_i$, with i running from 1 to N and the time spent at $\theta_i$ and $\phi_i$ being $T_i$, wherein $\Sigma T_i Y_{km}(\theta_i,\phi_i) = 0$ for m = -k to +k and $\Sigma T_i Y_{jm}(\theta_i,\phi_i) = 0$ for m = -j to +j.

**23.** The method of claim 22 wherein p = 2 and q = 4.

**24.** The method of Claim 23 wherein N = 6 and $T_i$ = T, a constant, for i = 1 to 6.

**25.** A method according to claim 14 further comprising the steps of generating a magnetic field in said sample; causing said sample to spin about a sample axis inclined at afirst angle, $\Theta_1$, with respect to the direction of said magnetic field; exciting said sample with a first electromagnetic pulse; allowing the magnetization of said sample to precess for a first time interval, $T_1$, after the cessation of said first electromagnetic pulse; exciting said sample with a second electromagnetic pulse having a predetermined phase relative to said first electromagnetic pulse which will cause one of the components of the magnetization to rotate around one coordinate axis so that this component is now parallel to the direction of the magnetic field (z-axis);

causing said sample axis to be inclined at a seconde angle, $\Theta_2$, with respect to the direction of said magnetic field; exciting said sample with a third electromagnetic pulse having a phase equal to said predetermined phase relative to said first electromagnetic pulse;

which will cause said component of the magnetization to rotate around one coordinate axis so that this component is now parallel to the x-axis; allowing the magnetization of said sample to process for a second time interval, $T_2$, after the cessation of said third electromagnetic pulse; and detecting the magnitude and phase of the electromagnetic energy emanating from said sample; wherein $\Theta_1$, $\Theta_2$, $T_1$, and $T_2$ are chosen such that $T_1 P_n(\cos(\Theta_1)) + T_2 P_n(\cos(\Theta_2)) = 0$ and $T_1 P_m(\cos(\Theta_1)) + T_2 P_m(\cos(\Theta_2)) = 0$, where $P_n$ and $P_m$ are Legendre polynomials of rank n and m, respectively, and n is not equal to m.

**26.** The method of Claim 25 wherein n = 2 and m = 4.

**27.** The method of Claim 25 wherein $T_1 = T_2$.

**28.** An apparatus according to claim 1 further comprising: means for generating a magnetic field in said sample; means for causing said sample to spin about a sample axis inclined at a first angle, $\Theta_1$, with respect to the direction of said magnetic field; first exciting means for exciting said sample with a first electromagnetic pulse thereto; second exciting means for exciting said sample with a second electromagnetic pulse having a phase equal to said predetermined phase relative to said first electromagnetic pulse which will cause one of the components of the magnetization to rotate around one coordinate axis so that this component is now parallel to the direction of the magnetic field, said second exciting means being operative at a time $T_1$ after the cessation of said first electromagnetic pulse; means for causing said sample axis to be inclined at a second angle, $\Theta_2$, with respect to the direction of said magnetic field; third exciting means for exciting said sample with a third electromagnetic pulse having a Predetermined phase relative to said first electromagnetic pulse which will cause said component of the magnetization to rotate around one coordinate axis so that this component is now parallel to the x-axis said third exciting means being operative after said sample axis has been inclined at $\theta_2$ with respect to the direction of said magnetic field; means for detecting the magnitude and phase of the electromagnetic energy emanating from said sample at a time $T_2$ after the cessation of said third electromagnetic pulse; wherein $\Theta_1$, $\Theta_2$, $T_1$, and $T_2$ are chosen such that $T_1 P_n(\cos(\Theta_1)) + T_2 P_n(\cos(\Theta_2)) = 0$ and $T_1 P_m(\cos(\Theta_1)) + T_2 P_m(\cos(\Theta_2)) = 0$, where $P_n$ and $P_m$ are Legendre polynomials of rank n and m, respectively, and n is not equal to m.

**29.** The apparatus of Claim 28 wherein n = 2 and m=4.

**30.** The apparatus of claim 28 wherein $T_1 = T_2$.

**Patentansprüche**

**1.** Vorrichtung zur Messung der NMR-Spektren eines Musters mit

einer Einrichtung (710) zum Halten des Musters in einem statischen Magnetfeld (712), wobei die Orientierung des Musters bezüglich der Richtung des statischen Magnetfeldes (712) durch einen Polarwinkel $\theta$ und einen Azimutalwinkel $\phi$ bestimmt ist, und
einer Orientierungseinrichtung (420) zum Bewirken einer Änderung der Orientierung des Musters relativ zu dem statischen Magnetfeld (712), wobei die Orientierung des Musters zur Zeit t gleich einem Polarwinkel $\theta(t)$ und einem Azimutalwinkel $\phi(t)$ ist,

**dadurch gekennzeichnet, daß**
die Orientierungseinrichtung zur Änderung der Orientierung des Musters bezüglich des statischen Magnetfeldes (712) derart eingerichtet ist, daß der zeitliche Durchschnitt jedes Satzes zweier Sätze von Kugelfunktionen $Y_{km}(\theta(t),\phi(t))$ mit m = -k bis +k und $Y_{jn}(\theta(t),\phi(t))$ mit n = -j bis +j Null ist, wobei k von j verschieden ist und sowohl k als auch von Null verschieden sind.

**2.** Vorrichtung nach Anspruch 1, **dadurch gekennzeichnet, daß** die Orientierungseinrichtung eine Einrichtung (420, 430) zum Bewirken aufweist, daß die Orientierung des Musters eine Folge diskreter Orientierungen relativ zu der Richtung (401) des statischen Magnetfeldes annimmt, wobei die i-te Orientierung durch einen Polarwinkel $\theta_i$ und einen Azimutalwinkel $\phi_i$ bestimmt ist, i von 1 bis N läuft und die an $\theta_i$ und $\phi_i$ verbrauchte Zeit $T_i$ ist, mit

$$\sum_{i=1}^{N} T_i Y_{km}(\theta_i, \phi_i) = 0$$

für m = -k bis +k und

$$\sum_{i=1}^{N} T_i Y_{jm}(\theta_i, \phi_i) = 0$$

für m = -j bis +j.

3. Vorrichtung nach Anspruch 1, **dadurch gekennzeichnet, daß** die Orientierungseinrichtung eine Einrichtung zum Drehen des Musters um eine Musterachse (604) und eine Schwenkeinrichtung (606) zum Bewirken eines Schwenkens der Musterachse (604) um einen festen Punkt davon zwischen einem ersten und zweiten Polarwinkel ($\theta_1$, $\theta_2$) bezüglich der Richtung des statischen Magnetfeldes (605) aufweist.

4. Vorrichtung nach Anspruch 3, **dadurch gekennzeichnet, daß** die Schwenkeinrichtung (606) ferner eine Einrichtung zum Bewirken einer Bewegung der Musterachse (604) mit einer konstanten Winkelgeschwindigkeit zwischen dem ersten und zweiten Polarwinkel ($\theta_1$, $\theta_2$) aufweist.

5. Vorrichtung nach Anspruch 3, **dadurch gekennzeichnet, daß** die Schwenkeinrichtung (606) ferner eine Einrichtung zum Bewirken eines Verweilens der Musterachse für ein erstes Zeitintervall bei dem ersten Polarwinkel ($\theta_1$), eine Einrichtung zum Bewirken einer Bewegung der Musterachse (604) zu dem zweiten Polarwinkel ($\theta_2$) und eine Einrichtung zum Bewirken eines Verweilens der Musterachse (604) für ein zweites Zeitintervall bei dem zweiten Polarwinkel ($\theta_2$) aufweist.

6. Vorrichtung nach Anspruch 3, **dadurch gekennzeichnet, daß** die Schwenkeinrichtung (606) ferner eine Einrichtung zum Bewirken einer Bewegung der Musterachse (604) zwischen dem ersten und dem zweiten Polarwinkel mit einer Winkelgeschwindigkeit, die sich mit der Zeit sinusförmig ändert, aufweist.

7. Vorrichtung nach Anspruch 1, **dadurch gekennzeichnet, daß** die Orientierungseinrichtung eine Einrichtung zum Bewirken einer Drehung der Musterhalteeinrichtung (2) um eine Musterachse (4), und eine Einrichtung zum Bewirken aufweist, daß die Musterachse (4) einen Kegel (5) mit einem vorbestimmten Öffnungswinkel ($\theta_2$) überstreicht, wobei die Achse des Kegels (5) mit einem vorbestimmten Winkel ($\theta_1$) gegenüber der Richtung des Magnetfeldes (8) geneigt ist.

8. Vorrichtung nach Anspruch 7, **dadurch gekennzeichnet, daß** die Musterhalteeinrichtung einen Zylinder (46) mit einem axialen Trägheitsmoment $I_{ax}$ und einem transversalen Trägheitsmoment $I_{tr}$ aufweist, die Einrichtung zum Bewirken der Drehung der Musterhalteeinrichtung eine Einrichtung zum Bewirken einer Drehung des Zylinders (46) mit einer Winkelgeschwindigkeit von $w_1$ Umdrehungen pro Sekunde aufweist und die Einrichtung zum Bewirken, daß die Musterachse einen Kegel überstreicht, die Achse zur Durchführung einer Umdrehung auf dem Kegel alle $1/w_{nut}$ Sekunden veranlaßt, wobei $w_1$ gleich $(I_{tr}-I_{ax})w_{nut} * \cos(\theta_2)/I_{ax}$ und $\theta_2$ der Neigungswinkel der Achse des Kegels relativ zu der Magnetfeldrichtung ist.

9. Vorrichtung nach Anspruch 7, **dadurch gekennzeichnet, daß** der Cosinus des Öffnungswinkels ($\theta_2$) Null für ein erstes Legendre-Polynom und der Cosinus des Neigungswinkels ($\theta_1$) Null für ein zweites Legendre-Polynom ist.

10. Vorrichtung nach Anspruch 7, **dadurch gekennzeichnet, daß** das erste Legendre-Polynom die Ordnung 2 und das zweite Legendre-Polynom die Ordnung 4 hat.

11. Vorrichtung nach Anspruch 7, **dadurch gekennzeichnet, daß** die Musterhalteeinrichung (652) einen Zylinder mit einem gerundeten Ende (653) umfaßt und der Zylinder Schaufeln (664, 666) an seiner Oberfläche aufweist, und die Einrichtung zum Bewirken der Drehung der Musterhalteeinrichtung um eine Musterachse (654) einen kegelstumpfförmigen Stator (662) mit einer mit dem vorbestimmten Winkel ($\theta_1$) bezüglich der Magnetfeldrichtung (660) geneigten Achse und einem Öffnungswinkel ($\theta_2$) gleich dem vorbestimmten Öffnungswinkel, wobei der Stator (662) ferner eine Einrichtung enthält, um das gerundete Ende in Eingriff zu bringen, und eine Einrichtung zum Richten von Luftstrahlen gegen die Schaufeln (664, 666) aufweist.

12. Vorrichtung nach Anspruch 11, **dadurch gekennzeichnet, daß** die Einrichtung zum Richten von Luftstrahlen eine Vielzahl von Einführungsöffnungen (670) in den Stator aufweist.

13. Vorrichtung nach Anspruch 7, **dadurch gekennzeichnet, daß** die Musterhalteeinrichtung einen ersten Zylinder (46) mit einem Abschnitt (56) darin zum Halten des Musters aufweist, wobei die Achse des ersten Zylinders mit der Musterachse zusammenfällt, die Einrichtung zum Bewirken der Drehung der Musterhalteeinrichtung eine Einrichtung zum Bewirken der Drehung des ersten Zylinders um seine Achse aufweist, und die Einrichtung zum Bewirken, daß die Musterachse einen Kegel überstreicht, einen zweiten Zylinder (50), wobei eine Einrichtung (47) zum Halten des ersten Zylinders derart enthalten ist, daß die Achse des ersten Zylinders mit dem Öffnungswinkel bezüglich der Achse des zweiten Zylinders geneigt ist, und die Achse des zweiten Zylinders mit dem Neigungswinkel bezüglich der Magnetfeldrichtung geneigt ist, und eine Einrichtung zum Bewirken einer Drehung des zweiten Zylinders (50) um seine Achse aufweist.

14. Verfahren zur Messung der NMK-Spektren eines Musters, mit den Schritten

Plazieren des Musters in einem statischen Magnetfeld (712), wobei die Orientierung des Musters bezüglich der Richtung des statischen Magnetfeldes (712) durch einen Polarwinkel $\theta$ und einen Azimutalwinkel $\phi$ bestimmt ist, und
Bewirken einer Änderung der Orientierung des Musters relativ zu dem statischen magnetfeld (712), wobei die Orientierung des Musters zur Zeit t gleich einem Polarwinkel $\theta(t)$ und einem Azimutalwinkel $\phi(t)$ ist,

**gekennzeichnet durch** den Schritt
Ändern der Orientierung des Musters bezüglich des statischen Magnetfeldes (712) derart, daß der zeitliche Durchschnitt jedes Satzes zweier Sätze von Kugel funktionen $Y_{km}(\theta(t),\phi(t))$ mit m = -k bis +k und $Y_{jn}(\theta(t),\phi(t))$ mit n = -j bis +j Null ist, wobei k von j verschieden ist und sowohl k als auch j von Null verschieden sind.

15. Verfahren nach Anspruch 14, **dadurch gekennzeichnet, daß** der Schritt zum Bewirken der Bewegung des Musters die Schritte

Drehen des Musters um eine Musterachse (604) und
Bewirken eines Schwenkens der Musterachse um ein festes Ende davon zwischen einem ersten und zweiten Winkel ($\theta_1$, $\theta_2$) bezüglich der Richtung des Magnetfeldes (605) aufweist.

16. Verfahren nach Anspruch 15, **dadurch gekennzeichnet, daß** der Schritt zum Bewirken des Schwenkens der Musterachse ferner den Schritt
Bewirken einer Bewegung der Musterachse (604) mit einer konstanten Winkelgeschwindigkeit zwischen dem ersten und dem zweiten Winkel ($\theta_1$, $\theta_2$) aufweist.

17. Verfahren nach Anspruch 15, **dadurch gekennzeichnet, daß** der Schritt zum Bewirken des Schwenkens der Musterachse (604) ferner die Schritte

Bewirken, daß die Musterachse für eine erste Zeit bei dem ersten Winkel ($\theta_1$) verbleibt,
Bewirken einer Bewegung der Musterachse zu dem zweiten Winkel ($\theta_2$) und
Bewirken, daß die Musterachse für eine zweite Zeit bei dem zweiten Winkel ($\theta_2$) verbleibt, aufweist.

18. Verfahren nach Anspruch 15, **dadurch gekennzeichnet, daß** der Schritt zum Bewirken des Schwenkens der Musterachse (604) ferner den Schritt
Bewirken einer Bewegung der Musterachse (604) zwischen dem ersten und dem zweiten Winkel mit einer Winkelgeschwindigkeit, die sich mit der Zeit sinusförmig ändert, aufweist.

19. Verfahren nach Anspruch 14, **dadurch gekennzeichnet, daß** das Bewirken der Bewegung des Musters relativ zu dem Magnetfeld die Schritte

Bewirken einer Drehung des Musters um eine Musterachse (4) und

Bewirken, daß die Musterachse (4) um einen Kegel (5) mit einem vorbestimmten Öffnungswinkel ($\theta_2$) streicht, wobei die Achse des Kegels (5) mit einem vorbestimmten Winkel ($\theta_1$) gegenüber der Richtung des Magnetfeldes (8) geneigt ist, aufweist.

20. Verfahren nach Anspruch 19, **dadurch gekennzeichnet, daß** der Cosinus des Öffnungswinkels ($\theta_2$) Null für ein erstes Legendre-Polynom und der Cosinus des Neigungswinkels ($\theta_1$) Null für ein zweites Legendre-Polynom ist.

21. Verfahren nach Anspruch 20, dadurch gekennzeichnet, daß das erste Legendre-Polynom die Ordnung 2 und das zweite Legendre-Polynom die Ordnung 4 aufweist.

22. Verfahren nach Anspruch 14, **dadurch gekennzeichnet, daß** tischen Magnetfeld den Schritt

Bewirken, daß die Orientatierung des Musters eine Folge diskreter Orientierungen relativ zu der Magnetfeldrichtung (401) annimmt, aufweist, wobei die i-te Orientierung durch einen Polarwinkel $\theta_i$ und einen Azimutalwinkel $\phi_i$ bestimmt wird, i von 1 bis N läuft und die an $\theta_i$ und $\phi_i$ verbrauchte Zeit $T_i$ ist, mit $\Sigma T_i Y_{km}(\theta_i,\phi_i) = 0$ für m = -k bis +k und $\Sigma T_i Y_{jm}(\theta_i,\phi_i) = 0$ für m = -j bis +j.

23. Verfahren nach Anspruch 22, **dadurch gekennzeichnet, daß** p=2 und q=4 ist.

24. Verfahren nach Anspruch 23, **dadurch gekennzeichnet, daß** N=6 und $T_i$=T eine Konstante für i = 1 bis 6 ist.

25. Verfahren nach Anspruch 14, **gekennzeichnet durch** die Schritte

Erzeugen eines Magnetfeldes in dem Muster,

Bewirken einer Drehung des Musters um eine mit einem ersten Winkel $\theta_1$ bezüglich der Richtung des Magnetfeldes geneigte Musterachse,

Anregen des Musters mit einem ersten elektromagnetischen Impuls,

Erlauben, daß die Magnetisierung des Musters für ein erstes Zeitintervall $T_1$ nach dem Aufhören des ersten elektromagnetischen Impulses eine Präzession aufweist,

Anregen des Musters mit einem zweiten elektromagnetischen Impuls mit einer vorbestimmten Phase relativ zu dem ersten elektromagnetischen Impuls, was eine der Komponenten der Magnetisierung zur Rotation um eine Koordinatenachse veranlaßt, so daß diese Komponente dann parallel zu der Richtung des Magnetfeldes (z-Achse) ist,

Bewirken, daß die Musterachse bei einem zweiten Winkel $\theta_2$ bezüglich der Richtung des Magnetfeldes geneigt wird,

Anregen des Musters mit einem dritten elektromagnetischen Impuls mit einer Phase gleich der vorbestimmten Phase relativ zu dem ersten elektromagnetischen Impuls, was die Komponente der Magnetisierung zur Rotation um eine Koordinatenachse veranlaßt, so daß diese Komponente dann parallel zu der x-Achse ist,

Erlauben, daß die Magnetisierung des Musters für ein zweites Zeitintervall $T_2$ nach dem Aufhören des dritten elektromagnetischen Impulses eine Präzession aufweist, und

Erfassen der Größe und Phase der von dem Muster ausgehenden elektromagnetischen Energie, wobei $\theta_1$, $\theta_2$, $T_1$ und $T_2$ derart gewählt werden, daß $T_1 P_n(\cos(\theta_1)) + T_2 P_n(\cos(\theta_2)) = 0$ und $T_1 P_m(\cos(\theta_1)) + T_2 P_m(\cos(\theta_2)) = 0$, wobei $P_n$ und $P_m$ Legendre-Polynome jeweils des Rangs n und m sind und n ungleich m ist.

26. Verfahren nach Anspruch 25, **dadurch gekennzeichnet, daß** n = 2 und m = 4 ist.

27. Verfahren nach Anspruch 25, wobei $T_1 = T_2$ ist.

28. Vorrichtung nach Anspruch 1, **gekennzeichnet durch**

eine Einrichtunq zur Erzeugung eines Magnetfeldes in dem Muster,

eine Einrichtung zum Bewirken einer Drehung des Musters um eine bei einem ersten Winkel $\theta_1$ bezüglich der Richtung des Magnetfeldes geneigte Musterachse,

eine erste Anregungseinrichtung zum Anregen des Musters mit einem ersten elektromagnetischen Impuls,

eine zweite Anregungseinrichtung zum Anregen des Musters mit einem zweiten elektromagnetischen Impuls mit einer Phase gleich der vorbestimmten Phase relativ zu dem ersten elektromagnetischen Impuls, was eine der Komponenten der Magnetisierung zur Rotation um eine Koordinatenachse veranlaßt, so daß diese Komponente dann parallel zu der Richtung des Magnetfeldes ist, wobei die zweite Anregungseinrichtung zu einer

Zeit $T_1$ nach dem Aufhören des ersten elektromagnetischen Impulses betriebsbereit ist,
eine Einrichtung zum Bewirken einer Neigung der Musterachse bei einem zweiten Winkel $\theta_2$ bezüglich der Richtung des Magnetfeldes,
eine dritte Anregungseinrichtung zum Anregen des Musters mit einem dritten elektromagnetischen Impuls mit einer vorbestimmten Phase relativ zu dem ersten elektromagnetischen Impuls, was die Komponente der Magnetisierung zur Rotation um eine Koordinatenachse veranlaßt, so daß diese Komponente dann parallel zu der x-Achse ist, wobei die dritte Anregungseinrichtung betriebsbereit ist, nachdem die Musterachse bei $\theta_2$ bezüglich der Richtung des Magnetfeldes geneigt wurde, und
eine Einrichtung zur Erfassung der Größe und Phase der von dem Muster ausgehenden elektromagnetischen Energie zu einer Zeit $T_2$ nach dem Aufhören des dritten elektromagnetischen Impulses, wobei $\theta_1$, $\theta_2$, $T_1$ und $T_2$, derart gewählt werden, daß $T_1 P_n(\cos(\theta_1)) + T_2 P_n(\cos(\theta_2)) = 0$ und $T_1 P_m(\cos(\theta_1)) + T_2 P_m(\cos(\theta_2)) = 0$, wobei $P_n$ und $P_m$ Legendre-Polynome jeweils des Rangs n und m sind und n ungleich m ist.

29. Vorrichtung nach Anspruch 28, **dadurch gekennzeichnet, daß** n = 2 und m = 4.

30. Vorrichtung nach Anspruch 28, **dadurch gekennzeichnet, daß** $T_1 = T_2$.


**Revendications**

1. Un dispositif de mesure du spectre NMR d'un échantillon, ledit dispositif comprenant:

    des moyens (710) conçus pour maintenir ledit échantillon dans un champ magnétique statique (712), l'orientation dudit échantillon par rapport à la direction dudit champ magnétique statique (712) étant spécifiée par un angle polaire $\theta$ et un angle azimutal $\phi$;

    des moyens d'orientation (420) conçus pour provoquer la variation de l'orientation dudit échantillon par rapport audit champ magnétique statique (712), l'orientation dudit échantillon à l'instant t étant égale à un angle polaire $\theta(t)$ et un angle azimutal $\phi(t)$ ;

    caractérisé en ce que
    les moyens d'orientation sont agencés pour provoquer le changement de l'orientation dudit éhantillon par rapport audit champ magnétique statique (712), de manière que la moyenne de temps de chacun des deux jeux de fonctions harmoniques sphériques $Y_{km}(\theta(t), \phi(t))$ pour m = -k à +k et $Y_{jn}(\theta(t), \phi(t))$ pour n = -j à +j soit égal à zéro, k étant différent de j et k et j étant, les deux, différents de zéro.

2. Le dispositif selon la revendication 1, dans lequel lesdits moyens d'orientation comprennent des moyens (420, 430) conçus pour provoquer, au niveau de l'orientation dudit échantillon, la prise d'une valeur d'orientation discrète successive par rapport à la direction (401) dudit champ magnétique, la iéme orientation étant spécifiée par un angle polaire $\theta_i$ et un angle azimutal $\phi_i$, y étant compris de 1 à N et le temps écoulé en $\theta_i$ et $\phi_i$ étant $T_i$, dans lequel

$$\sum_{i=1}^{N} T_i Y_{km}(\theta_i, \phi_i) = 0$$

pour mo = -k à +k et

$$\sum_{j=1}^{N} T_i Y_{jm}(\theta_i, \phi_i) = 0$$

pour m = -j à +j.

3. L'appareil selon la revendication 1, dans lequel lesdits moyens d'orientation comprennent :
    des moyens pour faire tourner ledit échantillon autour d'un axe d'échantillon (604); et des moyens de pivotement (606) conçus pour provoquer le pivotement dudit axe d'échantillon (604) autour d'un point fixe de celui-ci, entre des premier et deuxième angles polaires ($\theta_1$, $\theta_2$) par rapport à la direction dudit champ magnétique (605).

4. Le dispositif selon la revendication 3, dans lequel lesdits moyens de pivotement (606) comprennent en outre des moyens pour provoquer le déplacement dudit axe d'échantillon (604), à une vitesse angulaire constante, entre lesdits premier et deuxième angles polaires ($\theta_1$, $\theta_2$).

5. Le dispositif selon la revendication 3, dans lequel lesdits moyens de pivotement (606) comprennent en outre des moyens pour provoquer l'arrêt momentané dudit axe d'échantillon pendant un premier intervalle de temps à la valeur dudit premier axe polaire ($\theta_1$); des moyens pour provoquer le déplacement dudit axe d'échantillon (604) vers le deuxième angle polaire ($\theta_2$); et des moyens pour provoquer l'arrêt momentané dudit premier axe (604) pendant un deuxième intervalle de temps, à la valeur dudit deuxième angle polaire ($\theta_2$).

6. Le dispositif selon la revendication 3, dans lequel lesdits moyens de pivotement (606) comprennent en outre des moyens pour provoquer le déplacement dudit axe d'échantillon (604) entre lesdits premier et deuxième axes polaires, à une vitesse angulaire variant de façon sinusoïdale en fonction du temps.

7. Le dispositif selon la revendication 1, dans lequel lesdits moyens d'orientation comprennent : des moyens pour provoquer la rotation desdits moyens de maintien d'échantillon (2) autour d'un axe d'échantillon (4); des moyens pour provoquer le basculement dudit axe d'échantillon (4) hors d'un cône (5) ayant un angle d'ouverture ($\theta_2$) prédéterminé, l'axe dudit cône (5) étant incliné sous un angle ($\theta_1$) prédéterminé par rapport à la direction dudit champ magnétique (8).

8. L'appareil selon la revendication 7, dans lequel lesdits moyens de maintien d'échantillon comprennent un cylindre (46) ayant un moment d'inertie axial, $I_{ax}$, et un moment transversal $I_{tr}$, lesdits moyens conçus pour provoquer la rotation desdits moyens de maintien d'échantillon comprenant des moyens pour provoquer la rotation dudit cylindre (46) sous une vitesse angulaire de $w_1$ tours par seconde, et lesdits moyens pour provoquer le basculement dudit axe d'échantillon hors d'un cône provoquant la rotation dudit cône, à chaque $1/w_{nut}$ seconde, dans lequel $w_1$ est égal à $(I_{tr}-I_{ax})w_{nut}{}^*\cos(\theta_2)/I_{ax}$, $\theta_2$ étant l'angle d'inclinaison de l'axe dudit cône par rapport à ladite direction de champ magnétique.

9. Le dispositif selon la revendication 7, dans lequel le cosinus dudit angle d'ouverture ($\theta_2$) est un zéro d'un premier polynôme de Legendre et le cosinus dudit angle d'inclinaison ($\theta_1$) est un zéro d'un deuxième polynôme de Legendre.

10. Le dispositif selon la revendication 7, dans lequel ledit premier polynôme de Legendre est d'ordre 2 et ledit deuxième polynôme de Legendre est d'ordre 4.

11. Le dispositif selon la revendication 7, dans lequel lesdits moyens de maintien d'échantillon (652) comprennent un cylindre ayant une extrémité arrondie (653), ledit cylindre comprenant des rotors (664, 666) sur sa surface et dans lequel lesdits moyens conçus pour provoquer la rotation desdits moyens de maintien d'échantillon autour d'un axe d'échantillon (654) comprennent : un stator tronconique (662) ayant un axe incliné sous un angle $\theta_1$ prédéterminé par rapport à ladite direction de champ magnétique (660) et un angle d'ouverture ($\theta_2$) égal audit angle d'ouverture prédéterminé, ledit stator (662) comprenant en outre des moyens pour engager ladite extrémité arrondie; et des moyens pour diriger des jets d'air contre lesdits rotors (664, 666).

12. Le dispositif selon la revendication 11, dans lequel lesdits moyens pour diriger des jets d'air comprennent une pluralité d'orifices d'entrée (610) ménagés dans ledit stator.

13. Le dispositif selon la revendication 7, dans lequel lesdits moyens de maitien d'échantillon comprennent un premier cylindre (46) ayant un en son soin un compartiment (56) pour maintenir ledit échantillon, l'axe dudit premier cylindre étant coïncidant avec ledit axe d'échantillon, dans lequel lesdits moyens pour provoquer la rotation desdits moyens de maintien d'échantillon comprennent des moyens pour provoquer la rotation dudit premier cylindre autour de son axe, et dans lequel lesdits moyens pour provoquer le basculement dudit axe d'échantillon hors d'un cône comprend un deuxième cylindre (50) comprenant des moyens (47) pour maintenir ledit premier cylindre, de manière que l'axe dudit premier cylindre soit incliné sous ledit angle d'ouverture en référence l'axe dudit deuxième cylindre, l'axe du deuxième cylindre étant incliné sous la valeur dudit angle d'inclinaison en référence à ladite direction de champ magnétique; et des moyens pour provoquer la rotation dudit deuxième cylindre (50) autour de son axe.

14. Un procédé de mesure du spectre NMR d'un échantillon, ledit procédé comprenant les étapes consistant à : placer ledit échantillon dans un champ magnétique statique (712), l'orientation dudit échantillon par rapport à la direction dudit champ magnétique statique (712) étant spécifiée par un angle polaire θ et un angle azimutal ϕ; le changement de l'orientation dudit échantillon par rapport audit champ magnétique (712), l'orientation dudit échantillon à l'instant t étant égal à un angle polaire θ(t) et un angle azimutal ϕ(t), caractérisé par les étapes consistant à modifier l'orientation dudit échantillon par rapport audit champ magnétique (712), de manière que la moyenne de temps de chacun des deux jeux de fonctions harmoniques $Y_{km}(\theta(t),\phi(t))$ pour m= -k.à +k et $Y_{jn}(\theta(t), \phi(t))$ pour n = -j à +j soit égale à zéro, dans lequel k est différent de j et k et j sont, les deux, différent de zéro.

15. Le procédé selon la revendication 14 dans lequel ladite étape de provocation du déplacement dudit échantillon comprend : la rotation dudit échantillon autour d'un axe d'échantillon (604); et le pivotement dudit axe d'échantillon autour de son extrémité fixe entre des premier et deuxième angles ($\theta_1$, $\theta_2$) par rapport à la direction dudit champ magnétique (605).

16. Le procédé selon la revendication 15, dans lequel ladite étape de provocation du pivotement dudit axe d'échantillon comprend en outre la provocation du déplacement dudit axe d'échantillon (604) à une vitesse angulaire constante entre lesdits premier et deuxième angles ($\theta_1$, $\theta_2$).

17. Le procédé selon la revendication 15, dans lequel ladite étape de provocation du pivotement dudit axe d'échantillon (604) comprend en outre : l'arrêt momentané dudit axe d'échantillon pendant une première durée à la valeur dudit premier angle ($\theta_1$); la provocation du déplacement dudit axe d'échantillon vers ledit deuxième angle ($\theta_2$); et la provocation de l'arrêt momentané dudit échantillon pendant une deuxième durée, à la valeur dudit deuxième angle ($\theta_2$).

18. Le procédé selon la revendication 15, dans lequel ladite étape de provocation du pivotement dudit axe d'échantillon (604) comprend en outre la provocation du déplacement dudit axe échantillon (604) entre lesdits premier et deuxième angles à une vitesse angulaire qui varie de façon sinusoïdale en fonction du temps.

19. Le procédé selon la revendiccation 14, dans lequel la provocation dudit déplacement de l'échantillon par rapport audit champ magnétique comprend la provocation de la mtation dudit échantillon autour d'un axe d'échantillon (4); la provocation du basculement dudit axe d'échantillon (4) autour d'un cône (5) ayant un angle d'ouverture ($\theta_2$) prédéterminé, l'axe dudit cône (5) étant incliné sous un angle ($\theta_1$) prédéterminé par rapport à la direction dudit champ magnétique (8).

20. Le procédé selon la revendication 19, dans lequel dans lequel le cosinus dudit angle d'ouverture ($\theta_2$) est un zéro d'un premier polynôme de Legendre et le cosinus dudit angle d'inclinaison ($\theta_1$) est un zéro d'un deuxième polynôme de Legendre.

21. Le procédé selon la revendication 20, dans lequel ledit premier polynôme de Legendre est d'ordre 2 et ledit deuxième polynôme de Legendre est d'ordre 4.

22. Le procédé selon la revendication 14, dans lequel la provocation do ladite orientation dudit échantillon par rapport audit champ magnétique statique comprend la provocation de l'orientation dudit échantillon pour qu'il prenne une succession d'orientations discrètes par rapport à ladite direction de champ magnétique (401), la ième orientation étant spécifiée par un angle polaire $\theta_i$ et un angle azimutal $\phi_i$, i étant compris entre 1 et N, et le temps pris en $\theta_i$ et $\phi_i$ étant $T_i$; dans lequel $\Sigma\ T_i Y_{km}\ (\theta_i,\ \phi_i) = 0$ pour m = -k à + k et $\Sigma\ T_i Y_{jm}(\theta_i,\ \phi_i) = 0$ pour m = -j à +j.

23. Le procédé selon la revendication 22, dans lequel p = 2 et q = 4.

24. Le procédé selon la revendication 23, dans lequel n=6 et $T_i$ = T, une constante, pour i = 1 à 6.

25. Un procédé selon la revendication 14, comprenant en outre consistant à générer un champ magnétique dans ledit échantillon; provoquer la rotation dudit échantillon autour d'un axe d'échantillon incliné sous un premier angle, $\theta_i$, par rapport à la direction dudit champ magnétique, l'excitation dudit échantillon avec une première impulsion électromagnétique; la mise en précession de la magnétisation dudit échantillon pendant un premier intervalle de temps, T1, après la cessation de ladite première impulsion électromagnétique; l'excitation dudit échantillon avec une deuxième impulsion électromagnétique ayant phase, égale à ladite phase prédéterminée, par rapport à ladite première impulsion électromagnétique, provoquant la rotation de l'une des composantes de la magnétisation autour d'un axe de coordonnée de manière que cette composante soit à présent parallèle à la direction du champ magnétique (axe z);

l'inclinaison dudit axe d'échantillon à un deuxième angle, $\theta2$, par rapport à la direction dudit champ magnétique; l'excitation dudit échantillon avec une troisième impulsion électromagnétique ayant une phase égale à ladite phase prédéterminée par rapport à ladite première impulsion électromagnétique, provoquant la rotation de ladite composante de la magnétisation autour d'un axe de coordonnée, de manière que cette composante soit à présent parallèle à l'axe x;

la mise en précession de la magnétisation dudit échantillon pendant un deuxième intervalle de temps, $T_2$, après la cessation de ladite troisième impulsion électromagnétique; et la détection de l'amplitude et de la phase de l'énergie électromagnétique émanant dudit échantillon; dans lequel $\theta_1$, $\theta_2$, $T_1$, et $T_2$ sont choisis de manière que $T_1 P_n(\cos(\theta_1)) + T_2 P_n(\cos(\theta_2)) = 0$ et $T_1 P_m(\cos(\theta_1)) + T_2 P_m(\cos(\theta_2)) = 0$, dans lequel $P_n$ et $P_m$ sont des polynômes de Legendre d'ordre n et m, respectivement, et n n'étant pas égal à m.

**26.** Le procédé selon la revendication 25, dans lequel n = 2 et m = 4.

**27.** Le procédé selon la revendication 25, dans lequel $T_1 = T_2$.

**28.** Un dispositif selon la revendication 1, comprenant en outre : des moyens pour générer un champ magnétique dans ledit échantillon; de moyens pour provoquer la rotation dudit échantillon autour d'un axe d'échantillon incliné sous un premier angle, $\theta_i$, par rapport à la direction dudit champ magnétique; des premiers moyens d'excitation pour provoquer l'excitation dudit échantillon avec une première impulsion électromagnétique lui étant appliquée; des deuxièmes moyens d'excitation, pour provoquer l'excitation dudit échantillon avec une deuxième impulsion électromagnétique ayant une phase, égale à ladite phase prédéterminée, par rapport à ladite première impulsion électromagnétique, provoquant la rotation de l'une des composantes de la magnétisation autour d'un axe de coordonnée de manière que cette composante soit à présent parallèle à la direction du champ magnétique (axe z);

lesdits deuxièmes moyens d'excitation étant fonctionnels à un temps T1 après la cessation de laditepremière impulsion électromagnétique; des moyens pour provoquer l'inclinaison dudit axe d'échantillon à un deuxième angle, $\theta2$, par rapport à la direction dudit champ magnétique; des troisièmes moyens d'excitation, pour provoquer l'excitation dudit échantillon avec une troisième impulsion électromagnétique ayant une phase, égale à ladite phase prédéterminée, par rapport à ladite première impulsion électromagnétique, provoquant la rotation de l'une des composantes de la magnétisation autour d'un axe de coordonnée de manière que cette composante soit à présent parallèle à la direction du champ magnétique (axe z);

lesdits troisièmes moyens d'excitation étant fonctionnels après que ledit axe d'échantillon ait été incliné à $\theta2$ par rapport à la direction dudit champ magnétique; des moyens pour la détection de l'amplitude et de la phase de l'énergie électromagnétique émanant dudit échantillon à un temps T2 après la cessation de ladite troisième impulsion électromagnétique; dans lequel $\theta_1$, $\theta_2$, $T_1$, et $T_2$ sont choisis de manière que $T_1 P_n(\cos(\theta_1)) + T_2 P_n (\cos(\theta_2)) = 0$ et $T_1 P_m(\cos(\theta_1)) + T_2(P_m(\cos(\theta_2)) = 0$, dans lequel $P_n$ et $P_m$ sont des polynômes de Legendre d'ordre n et m, respectivement, et n n'étant pas égal à m.

**29.** Dispositif selon la revendication 28, dans lequel n = 2 et m = 4.

**30.** Le dispositif selon la revendication 28 dans lequel $T_1 = T_2$.

FIGURE 1

EP 0 427 759 B1

FIG. 2a-2   FIG. 2b-2   FIG. 2c-2   FIG. 2d-2   FIG. 2e-2   FIG. 2f-2

$\Omega_1$   $\Omega_1$   $\Omega_1$   $\Omega_2$   $\Omega_2$   $\Omega_N$

MAGNETIC FIELD

$t = 0$   $t = 0+$   $t = T_1-$   $t = T_1$   $t = (T_1 + T_2)-$   $t = (T_1 + \ldots + T_N)$

FIG. 2a-1   FIG. 2b-1   FIG. 2c-1   FIG. 2d-1   FIG. 2e-1   FIG. 2f-1

EP 0 427 759 B1

Z

$\Omega_1$

X

Y

FIG. 3a-2

Z

$\Omega_1$

X

Y

FIG. 3b-2

Z

$\Omega_2$

X

Y

FIG. 3c-2

Z

$\Omega_2$

X

Y

FIG. 3d-2

Z

$\Omega_2$

X

Y

FIG. 3e-2

Z

$M_y$  $M_x$  X

Y

$\emptyset_1$

FIG. 3a-1

Z

$M_x$

$M_y$

X

Y

FIG. 3b-1

Z

$M_x$

X

Y

FIG. 3c-1

Z

$M_x$  X

Y

FIG. 3d-1

Z

X

Y

$\emptyset_2$  $M_x$

FIG. 3e-1

FIG. 4a-2  FIG. 4b-2  FIG. 4c-2  FIG. 4d-2  FIG. 4e-2

FIG. 4a-1  FIG. 4b-1  FIG. 4c-1  FIG. 4d-1  FIG. 4e-1

EP 0 427 759 B1

FIGURE 5

FIGURE 6

EP 0 427 759 B1

FIG. 7a-2    FIG. 7b-2    FIG. 7c-2    FIG. 7d-2    FIG. 7e-2

FIG. 7a-1    FIG. 7b-1    FIG. 7c-1    FIG. 7d-1    FIG. 7e-1

EP 0 427 759 B1

EP 0 427 759 B1

FIG. 8a-2    FIG. 8b-2    FIG. 8c-2    FIG. 8d-2    FIG. 8e-2

FIG. 8a-1    FIG. 8b-1    FIG. 8c-1    FIG. 8d-1    FIG. 8e-1

FIG. 9a-2    FIG. 9b-2    FIG. 9c-2    FIG. 9d-2    FIG. 9e-2

FIG. 9a-1    FIG. 9b-1    FIG. 9c-1    FIG. 9d-1    FIG. 9e-1

EP 0 427 759 B1

FIG. 10

FIG. 11

FIGURE 12

EP 0 427 759 B1

FIGURE 13

FIG. 14(a)

FIG. 14(b)

FIG. 14(c)

500

*FIGURE 15*